# EUROPEAN PATENT APPLICATION

(11) **EP 4 797 538 A1**
(43) Date of publication of application: **26.08.2026**
(21) Application number: 24884654.5
(22) Date of filing: 28.10.2024
(51) Int. Cl.: H03M 7/30

(54) **DATA PROCESSING METHOD, APPARATUS, DEVICE, STORAGE MEDIUM AND PROGRAM PRODUCT**

(30) Priority: 31.10.2023 CN 202311439018
(71) Applicant: HUAWEI TECHNOLOGIES CO., LTD., Shenzhen 518129 (CN)
(72) Inventor: TANG, Zihan, Shenzhen, Guangdong 518129 (CN); MA, Mengyao, Shenzhen, Guangdong 518129 (CN); XIE, Junwen, Shenzhen, Guangdong 518129 (CN)
(74) Representative: Goddar, Heinz J.
(86) International application number: PCT/CN2024/127733
(87) International publication number: WO 2025/092651

(57) **Abstract**

Embodiments of this application provide a data processing method and device, a storage medium, and a program product. In the method, a data compression apparatus obtains to-be-compressed data, and performs L times of iterative approximation on the to-be-compressed data, where the L times of iterative approximation include: respectively selecting L column vectors from L codebook matrices to perform approximation on the to-be-compressed data, and elements in the L codebook matrices include two different values; and generating, based on L column numbers of the L column vectors in the L codebook matrices, compressed data obtained by compressing the to-be-compressed data. In this way, an original signal is approximated by using a small codebook with two different values, thereby reducing search and storage overheads and improving execution efficiency.

## Description

This application claims priority to Chinese Patent Application No. 202311439018.7, filed with the China National Intellectual Property Administration on October 31, 2023 and entitled "DATA PROCESSING METHOD AND DEVICE, APPARATUS, STORAGE MEDIUM, AND PROGRAM PRODUCT", which is incorporated herein by reference in its entirety.

### TECHNICAL FIELD

Embodiments of this application generally relate to the communication field, and more specifically, to a data processing method, a terminal device, a network device, a computer-readable storage medium, and a computer program product.

### BACKGROUND

For compression of high-dimensional vector data, transform domain compression based on dictionary learning (referred to as "dictionary compression" for short) is a highly effective compression method. However, dictionary compression is highly complex, which is not conducive to implementation on a terminal device with a poor computing capability. However, implementing dictionary compression on a network side adversely affects multi-channel concurrency and system capacity expansion. Therefore, a data compression method with low complexity is urgently needed.

### SUMMARY

Embodiments of this application provide a technical solution for data compression, which can provide a lossy compression solution with lower complexity than dictionary learning-based compression. Some embodiments of this disclosure are applicable to compression of any high-dimensional vector data, for example, can achieve better effect than dictionary compression and scalar quantization in compression of non-structured source data, and have lower complexity than dictionary compression, which facilitates hardware implementation. Some embodiments of this disclosure may be oriented to, for example, a future wireless communication system, such as a next generation cellular system or a short-range wireless communication system (such as Wi-Fi or UWB), and may be widely used in a terminal device or a network side device in a future wireless communication scenario.

According to a first aspect, a data processing method is provided. The method may be performed by a first device (data compression apparatus). Unless otherwise specified, the "first device" in this application may be the first device (for example, a terminal device or a network device), may be a component (for example, a processor, a chip, or a chip system) in the first device, or may be a logical module or software that can implement all or a part of functions of the first device. The following provides descriptions by using an example in which the method is performed by the first device. In the method, the first device obtains to-be-compressed data, and performs L times of iterative approximation on the to-be-compressed data, where the L times of iterative approximation include: respectively selecting L column vectors from L codebook matrices to perform approximation on the to-be-compressed data, where elements in the L codebook matrices include two different values; and generates, based on the L column vectors, compressed data obtained by compressing the to-be-compressed data. In this way, an original signal is approximated by using a small codebook of ±1, thereby reducing search and storage overheads.

In some implementations, the two different values are 1 and -1, so that a multiplication operation is converted into an addition or subtraction operation, thereby further reducing calculation and storage overheads.

In some implementations, the first device may generate, based on L column numbers of the L column vectors in the L codebook matrices or based on the L column vectors, the compressed data obtained by compressing the to-be-compressed data. In this way, calculation and storage overheads are reduced, and computational operations are simplified.

In some implementations, performing an i^{th} time of iterative approximation of the L times of iterative approximation includes: determining, based on a to-be-approximated vector, an i^{th} column vector in the L column vectors in an i^{th} codebook matrix in the L codebook matrices. In the i^{th} time of iterative approximation, the to-be-approximated vector is determined based on a residual vector corresponding to an (i-1)^{th} time of iterative approximation. In a first time of iterative approximation, the to-be-approximated vector is the to-be-compressed data, where L is greater than 1, and i is less than or equal to L. The residual vector corresponding to the (i-1)^{th} time of iterative approximation is an error in the (i-1)^{th} time of iterative approximation. In this way, a residual may be iteratively reduced, and an amount of transmitted data may be reduced by determining only the i^{th} column vector.

In some implementations, performing the i^{th} time of iterative approximation of the L times of iterative approximation further includes: approximating the to-be-approximated vector by using the i^{th} column vector and an i^{th} coefficient corresponding to the i^{th} column vector. In this way, a simple codebook may be used, and an amount of transmitted data may be reduced.

In some implementations, performing the i^{th} time of iterative approximation of the L times of iterative approximation further includes: determining an i^{th} residual vector between the to-be-approximated vector and a product of the i^{th} column vector multiplied by the i^{th} coefficient. In this way, a reduced residual may be iteratively determined, thereby iteratively improving fitting precision of each time of iteration.

In some implementations, determining, based on the to-be-approximated vector, the i^{th} column vector in the i^{th} codebook matrix includes: determining, from a plurality of column vectors in the i^{th} codebook matrix, a column vector that has maximum correlation with the to-be-approximated vector as the i^{th} column vector. In this way, a fitting error can be iteratively minimized, to achieve more accurate fitting.

In some implementations, L is determined in any one of the following manners: a preset value; or a comparison between a residual of the i^{th} time of iteration and a predetermined threshold. In this way, end time of iteration can be determined properly.

In some implementations, the data compression method further includes: performing a matrix row permutation on an (i-1)^{th} codebook matrix used in the (i-1)^{th} time of iterative approximation to obtain the i^{th} codebook matrix used in the i^{th} time of iterative approximation. In this way, a codebook matrix can be iteratively obtained in a simple manner, thereby reducing a calculation amount.

In some implementations, the matrix row permutation includes one of the following: a random matrix row permutation; or a forward or backward matrix row cyclic shift based on a pre-determined shift amount. In this way, the random permutation has better performance, while the matrix row cyclic shift can simplify system implementation.

In some implementations, the first device uses one of the following: using a same random matrix row permutation in a second time of iterative approximation to an L^{th} time of iterative approximation; or respectively determining a random matrix row permutation used in the second time of iterative approximation to the L^{th} time of iterative approximation. In this way, the row permutation may be performed in different manners, offering flexibility.

In some implementations, a first codebook matrix used in the first time of iterative approximation is randomly generated or predetermined. In this way, the codebook matrix can be initialized more flexibly. In some implementations, a random number seed used to determine the random matrix row permutation may be the same as or different from a random number seed used to randomly generate the first codebook matrix.

In some implementations, the L codebook matrices used in the L times of iterative approximation are the same, and the method performed by the first device further includes: performing an element permutation on an (i-1)^{th} residual vector determined in the (i-1)^{th} time of iterative approximation, to obtain the to-be-approximated vector in the i^{th} time of iterative approximation. In this way, the matrix permutation may be replaced with the element permutation, thereby simplifying system implementation and improving efficiency.

In some implementations, the element permutation includes one of the following: a random element permutation; or a forward or backward element cyclic shift based on a pre-determined shift amount. In this way, the element permutation may be performed equivalently to the matrix row permutation. The random permutation has better performance, while the element cyclic shift can simplify system implementation.

In some implementations, the method performed by the first device further includes: determining the i^{th} coefficient based on a dimension n of the to-be-compressed data, an element variance σ of the to-be-compressed data, a column quantity m of the L codebook matrices, and a quantity i of times of iterative approximation. In this way, each coefficient is accurately determined, and an error after compression is reduced.

In some implementations, the i^{th} coefficient is further determined based on a residual attenuation coefficient q, where the residual attenuation coefficient q represents an attenuation rate of a sum of squares of elements of a residual vector. In this way, each coefficient is accurately determined, and an error after compression is reduced.

In some implementations, the data compression method is performed by the first device, and the method further includes: sending, to a second device, the compressed data obtained by compressing the to-be-compressed data. In this way, the second device performs decompression.

In some implementations, the compressed data includes at least one of the following: the L column numbers, an element mean µ of the to-be-compressed data, the element variance σ of the to-be-compressed data, or a first coefficient used in the first time of iterative approximation. In this way, transmission of the compressed data can be simplified.

In some implementations, the data compression method is performed by the first device, and the method further includes: configuring or indicating, to the second device, at least one of the following: a compression manner of at least one of the element mean µ of the to-be-compressed data, the element variance σ of the to-be-compressed data, or the first coefficient used in the first time of iterative approximation; the dimension n of the to-be-compressed data and the column quantity m of the L codebook matrices; the residual attenuation coefficient q, where the residual attenuation coefficient q represents the attenuation rate of the sum of the squares of elements of the residual vector; whether the first codebook matrix in the L codebook matrices is randomly generated or predetermined; whether to perform the matrix row permutation on the (i-1)^{th} codebook matrix used in the (i-1)^{th} time of iterative approximation, or perform the element permutation on the (i-1)^{th} residual vector determined in the (i-1)^{th} time of iterative approximation; or whether the matrix row permutation or the element permutation is a random permutation or a cyclic shift. In this way, the first device and the second device are accurately synchronized, to facilitate data compression and decompression.

In some implementations, the compression manner includes at least one of the following: floating-point number representation; uniform scalar quantization; or skipping sending the element mean µ of the to-be-compressed data. In this way, the data compression manner is accurately identified.

In some implementations, the column quantity m of the L codebook matrices is determined based on a value of the dimension n. In this way, system implementation can be simplified.

In some implementations, the first codebook matrix is randomly generated, and the method performed by the first device further includes: configuring or indicating, to the second device, a random number seed used to generate the first codebook matrix.

In some implementations, the matrix row permutation or the element permutation is a random permutation, and the method performed by the first device further includes: configuring or indicating, to the second device, at least one of the following: whether the same random matrix row permutation or the respectively randomly generated matrix row permutation is used in the second time of iterative approximation to the L^{th} time of iterative approximation; or whether the random matrix row permutation reuses the random number seed used to generate the first codebook matrix in the L codebook matrices, or is configured with different random number seeds. In this way, configuration can be flexible.

In some implementations, the matrix row permutation or the element permutation is a cyclic shift, and the method performed by the first device further includes: configuring or indicating, to the second device, at least one of the following: a forward cyclic shift or a backward cyclic shift; or a shift amount. In this way, an implementation of the cyclic shift can be clearly indicated.

In some implementations, the data compression method is performed by the first device, and the method further includes: sending a first message to the second device, where the first message is used to request, from the second device, a resource used to send the compressed data to the second device. In this way, a proper resource may be requested to transmit the compressed data.

In some implementations, the first message includes at least one of the following: information that directly indicates a quantity L of times of iterative approximation, or a data volume of the compressed data. In this way, a request for the resource used for data transmission can be accurately performed.

In some implementations, the data compression method is performed by the first device. The method further includes: receiving a second message from the second device, where the second message indicates the resource that is scheduled by the second device to the first device and that is used to send the compressed data to the second device; and sending the compressed data to the second device using the scheduled resource. In this way, the second device may determine the resource used by the first device to send the compressed data.

In some implementations, at least one of the first message or the second message includes indication information, and the indication information indicates that the resource is used for incremental transmission. In this way, the compressed data may be iteratively transmitted in an incremental transmission manner.

In some implementations, the compressed data sent by the first device to the second device corresponds to basic transmission data, and sending the compressed data to the second device includes: determining that a quantity of times of iterative approximation corresponding to the compressed data sent by using the resource scheduled based on the second message is L1, where L1 is less than L; and sending, to the second device, a first column number to an L1^{th} column number in the L column numbers. In this way, an amount of transmitted data can be reduced by sending the basic transmission data.

In some implementations, the indication information in the second message indicates that the resource is used for incremental transmission, compressed data of L1 times of iterative approximation has been sent in basic transmission before incremental transmission, sending the compressed data to the second device includes: determining that the quantity of times of iterative approximation corresponding to the compressed data sent by using the resource scheduled based on the second message is L2-L1, where L1 is less than L2, and L2 is less than or equal to L; and sending, to the second device, an (L1+1)^{th} column number to an L2^{th} column number in the L column numbers. In this way, a compression error may be reduced by using incremental data.

In some implementations, determining the quantity of times of iterative approximation corresponding to the compressed data sent by using the resource scheduled based on the second message includes: when the resource is used for the compressed data alone, determining the quantity of times of iterative approximation based on a quantity of resources; or when the resource is used for the compressed data and other data, obtaining indication information of the quantity of times of iterative approximation from the second message. In this way, resources can be properly scheduled.

According to a second aspect, a data processing method is provided. The method may be performed by a second device (data decompression apparatus). Unless otherwise specified, the "second device" in this application may be the second device (for example, a network device or a terminal device), may be a component (for example, a processor, a chip, or a chip system) in the second device, or may be a logical module or software that can implement all or a part of functions of the second device. The following provides descriptions by using an example in which the method is executed by the second device. In the method, the second device obtains, from compressed data obtained by compressing to-be-compressed data, L column numbers of L column vectors in L codebook matrices, where elements in the L codebook matrices are two different values; determines the L column vectors based on the L column numbers and the L codebook matrices; determines L coefficients corresponding to the L column vectors; and obtains an approximation of the to-be-compressed data based on the L coefficients and the L column vectors, where L is greater than or equal to 1. In this way, the approximation of the to-be-compressed data may be obtained by using the L column numbers and the corresponding L coefficients, and the data is approximately restored in a brief manner.

In some implementations, the two different values are 1 and -1, so that a multiplication operation is converted into an addition or subtraction operation, thereby further reducing calculation and storage overheads.

In some implementations, a first codebook matrix in the L codebook matrices is randomly generated or predetermined. In this way, the codebook matrix may be initialized, and synchronized with a first device.

In some implementations, the method performed by the second device further includes: performing a matrix row permutation on an (i-1)^{th} codebook matrix in the L codebook matrices, to obtain an i^{th} codebook matrix in the L codebook matrices. In this way, a codebook matrix used for decompression may be iteratively obtained.

In some implementations, the matrix row permutation includes one of the following: a random matrix row permutation; or a forward or backward matrix row cyclic shift based on a pre-determined shift amount. This offers some flexibility.

In some implementations, the second device may obtain a second codebook matrix to an L^{th} codebook matrix from the first codebook matrix to an (L-1)^{th} codebook matrix based on a same random matrix row permutation. Alternatively, the second device may obtain the second codebook matrix to the L^{th} codebook matrix from the first codebook matrix to the (L-1)^{th} codebook matrix based on a respectively determined random matrix row permutation. This is more flexible. In some implementations, a random number seed used to determine the random matrix row permutation is the same as or different from a random number seed used to randomly generate the first codebook matrix, thereby offering flexibility.

In some implementations, the L codebook matrices are the same, and obtaining the approximation of the to-be-compressed data based on the L coefficients and the L column vectors includes: respectively multiplying the L coefficients and the L column vectors to obtain L product column vectors; performing an element permutation one or more times on L-1 product column vectors other than a first product column vector, to obtain L product column vectors obtained through the element permutation; and summing up the L product column vectors obtained through the element permutation to obtain the approximation of the to-be-compressed data. In this way, the approximation of the to-be-compressed data may be obtained through the element permutation, to achieve same effect as the matrix row permutation, and simplify calculation.

In some implementations, the element permutation includes one of the following: a random element permutation, or a forward or backward element cyclic shift based on a pre-determined shift amount. This offers some flexibility.

In some implementations, the method performed by the second device further includes: determining an i^{th} coefficient corresponding to the i^{th} codebook matrix based on a dimension n of the to-be-compressed data, an element variance σ of the to-be-compressed data, a column quantity m of the L codebook matrices, and a sequence number i of the codebook matrix. In this way, accurate decompression can be performed.

In some implementations, the i^{th} coefficient is further determined based on a residual attenuation coefficient q, where the residual attenuation coefficient q represents an attenuation rate of a sum of squares of elements of a residual vector in a process of performing iterative approximation encoding on the to-be-compressed data. In this way, the coefficient used for decompression can be accurately determined.

In some implementations, the decompression method is performed by the second device, and the method further includes: receiving, from the first device, the compressed data obtained by compressing the to-be-compressed data. This facilitates data decompression.

In some implementations, the compressed data includes at least one of the following: the L column numbers; an element mean µ of the to-be-compressed data; the element variance σ of the to-be-compressed data; or a first coefficient corresponding to a first column vector. In this way, accurate decompression can be performed.

In some implementations, the decompression method is performed by the second device, and the method further includes: configuring at least one of the following or receiving, from the first device, information indicating least one of the following: a compression manner of at least one of the element mean µ of the to-be-compressed data, the element variance σ of the to-be-compressed data, or the first coefficient corresponding to the first column vector; the dimension n of the to-be-compressed data and the column quantity m of the L codebook matrices; the residual attenuation coefficient q, where the residual attenuation coefficient q represents the attenuation rate of the sum of the squares of elements in the residual vector in the process of performing iterative approximation encoding on the to-be-compressed data; whether the first codebook matrix in the L codebook matrices is randomly generated or predetermined; whether to perform the matrix row permutation on the (i-1)^{th} codebook matrix or perform the element permutation on a product vector of a column vector and a coefficient; or whether the matrix row permutation or the element permutation is a random permutation or a cyclic shift. In this way, accurate decompression can be performed.

In some implementations, the compression manner includes at least one of the following: floating-point number representation; uniform scalar quantization; or skipping sending the element mean µ of the to-be-compressed data. In this way, accurate decompression can be performed.

In some implementations, the column quantity m of the L codebook matrices is determined based on a value of the dimension n. In this way, a dimension of a codebook matrix can be properly determined.

In some implementations, the first codebook matrix is randomly generated, and the decompression method further includes: configuring a random number seed used to generate the first codebook matrix or receiving, from the first device, information indicating the random number seed. This helps the decompression apparatus accurately generate the first codebook matrix for decompression.

In some implementations, the matrix row permutation or the element permutation is a random permutation, and the decompression method further includes: configuring at least one of the following or receiving, from the first device, information indicating at least one of the following: whether the same random matrix row permutation or the respectively randomly generated matrix row permutation is used for the second codebook matrix to the L^{th} codebook matrix; or whether the random matrix row permutation reuses the random number seed used to generate the first codebook matrix in the L codebook matrices, or is configured with different random number seeds. In this way, proper configuration can be performed, and accurate decompression can be performed.

In some implementations, the matrix row permutation or the element permutation is a cyclic shift, and the decompression method further includes: configuring at least one of the following or receiving, from the first device, information indicating at least one of the following: a forward cyclic shift or a backward cyclic shift; or a shift amount. In this way, the cyclic shift can be accurately configured.

In some implementations, the decompression method is performed by the second device, and the method further includes: receiving a first message from the first device, where the first message is used to request, from the second device, a resource used to send the compressed data to the second device. In this way, the second device may allocate a proper resource to the first device.

In some implementations, the first message includes at least one of the following: information that directly indicates a quantity L of codebook matrices; or a data volume of the compressed data. In this way, a required resource may be indicated.

In some implementations, the decompression method is performed by the second device, and the decompression method further includes: sending a second message to the first device, where the second message indicates the resource that is scheduled by the second device to the first device and that is used to send the compressed data to the second device; and receiving the compressed data from the first device using the scheduled resource. In this way, a proper transmission resource may be scheduled for the first device to transmit the compressed data.

In some implementations, at least one of the first message or the second message includes indication information, and the indication information indicates that the resource is used for incremental transmission. In this way, incremental transmission can be accurately indicated.

In some implementations, the compressed data received from the first device corresponds to basic transmission data, and receiving the compressed data from the first device includes: when a quantity of codebook matrices corresponding to the compressed data sent by using the resource scheduled based on the second message is L1, receiving, from the first device, a first column number to an L1^{th} column number in the L column numbers, where L1 is less than L. In this way, the basic transmission data can be accurately decompressed, and the compressed data can be approximated.

In some implementations, the indication information in the second message indicates that the resource is used for incremental transmission, compressed data of L1 codebook matrices has been received in basic transmission before incremental transmission, and receiving the compressed data from the first device includes: when a quantity of codebook matrices corresponding to the compressed data sent by using the resource scheduled based on the second message is L2-L1, receiving, from the first device, an (L1+1)^{th} column number to an L2^{th} column number in the L column numbers, where L1 is less than L2, and L2 is less than or equal to L. In this way, incremental decompression is performed, and an error of the decompressed data is improved.

In some implementations, when the resource is used for compressed data alone, the second message does not include indication information indicating the quantity of codebook matrices. Alternatively, when the resource is used for the compressed data and other data, the second message includes indication information indicating the quantity of codebook matrices. This facilitates data decompression.

According to a third aspect, an apparatus is provided. The apparatus may be the first device (data compression apparatus) in the foregoing method embodiments. The "first device" may refer to the first device itself (for example, a terminal device or a network device), may be a component (for example, a processor, a chip, or a chip system) in the first device, or may be a logical module or software that can implement all or a part of functions of the first device. The apparatus includes: a to-be-compressed data obtaining module, configured to obtain to-be-compressed data; an iterative approximation module, configured to perform L times of iterative approximation on the to-be-compressed data, where the L times of iterative approximation include: respectively selecting L column vectors from L codebook matrices to perform approximation on the to-be-compressed data, and elements in the L codebook matrices include two different values; and a compressed data generation module, configured to generate, based on L column numbers of the L column vectors in the L codebook matrices, compressed data obtained by compressing the to-be-compressed data. In this way, an original signal is approximated by using a small codebook of ±1, thereby reducing search and storage overheads.

According to a fourth aspect, an apparatus is provided. The apparatus may be the second device (data decompression apparatus) in the foregoing method embodiments. The "second device" may refer to the second device itself (for example, a network device or a terminal device), may be a component (for example, a processor, a chip, or a chip system) in the second device, or may be a logical module or software that can implement all or a part of functions of the second device. The apparatus includes: a column number obtaining module, configured to obtain, from compressed data obtained by compressing to-be-compressed data, L column numbers of L column vectors in L codebook matrices, where elements in the L codebook matrices are two different values; a column vector determining module, configured to determine the L column vectors based on the L column numbers and the L codebook matrices; a coefficient determining module, configured to determine L coefficients corresponding to the L column vectors; and an approximate vector obtaining module, configured to obtain an approximation of the to-be-compressed data based on the L coefficients and the L column vectors, where L is greater than or equal to 1. In this way, the approximation of the to-be-compressed data may be obtained by using the L column numbers and the corresponding L coefficients, and the data is approximately restored in a brief manner.

According to a fifth aspect, a data processing device is provided. The data processing device may be the first device (data compression apparatus) in the foregoing method embodiments, or may be a chip disposed in the first device. The communication device includes a processor and a memory. The memory is configured to store a computer program or instructions. When the processor runs the computer program or the instructions, the first device is enabled to perform the method performed by the first device in the foregoing method embodiments.

According to a sixth aspect, a data processing device is provided. The data processing device may be the second device (data decompression apparatus) in the foregoing method embodiments, or may be a chip disposed in the second device. The communication device includes a processor and a memory. The memory is configured to store a computer program or instructions. When the processor runs the computer program or the instructions, the second device is enabled to perform the method performed by the second device in the foregoing method embodiments.

According to a seventh aspect, this application provides a computer-readable storage medium. The computer-readable storage medium stores machine-executable instructions. When the machine-executable instructions are run, the method performed by the first device in the foregoing aspects is implemented.

According to an eighth aspect, this application provides a computer-readable storage medium. The computer-readable storage medium stores machine-executable instructions. When the machine-executable instructions are run, the method performed by the second device in the foregoing aspects is implemented.

According to a ninth aspect, a computer program product is provided. The computer program product includes computer program code. When the computer program code runs, the method performed by the first device in the foregoing aspects is performed.

According to a tenth aspect, a computer program product is provided. The computer program product includes computer program code. When the computer program code is run, the method performed by the second device in the foregoing aspects is performed.

### BRIEF DESCRIPTION OF DRAWINGS

FIG. 1A shows a communication system in which embodiments of this application may be implemented;
FIG. 1B is a diagram of dictionary compression according to this application;
FIG. 2 is a flowchart of a data compression method according to an embodiment of this application;
FIG. 3 is a diagram of performing compression approximation by using a plurality of rounds of codebook matrices according to an embodiment of this application;
FIG. 4 is a flowchart of a data decompression method according to an embodiment of this application;
FIG. 5 is a diagram of performing a row permutation on a codebook matrix according to an embodiment of this application;
FIG. 6 is a diagram of performing a random row permutation on a codebook matrix according to an embodiment of this application;
FIG. 7 is a diagram of performing a row cyclic shift on a codebook matrix according to an embodiment of this application;
FIG. 8 is a diagram of performing a permutation on a residual vector according to an embodiment of this application;
FIG. 9 is a diagram of performing a random permutation on a residual vector according to an embodiment of this application;
FIG. 10 is a diagram of performing a row cyclic shift on a residual vector according to an embodiment of this application;
FIG. 11 is a diagram of a data part exchanged between a data compression apparatus and a data decompression apparatus according to an embodiment of this application;
FIG. 12 is a diagram of basic transmission and incremental transmission according to an embodiment of this application;
FIG. 13 shows an interaction procedure of basic transmission and incremental transmission according to an embodiment of this application;
FIG. 14 is a diagram of a simulation result of an independent and identically distributed Gaussian source according to an embodiment of this application;
FIG. 15 is a diagram of a simulation result of an independent and identically distributed Laplace source according to an embodiment of this application;
FIG. 16 is a diagram of a test result on an artificial intelligence (AI) model according to an embodiment of this application;
FIG. 17 is a diagram of parameter distribution on an AI model according to an embodiment of this application;
FIG. 18 is a diagram of parameter distribution on an AI model according to another embodiment of this application;
FIG. 19 is a simplified block diagram of an example device in a possible implementation according to an embodiment of this application;
FIG. 20 is a simplified block diagram of a communication apparatus in a possible implementation according to an embodiment of this application; and
FIG. 21 is a simplified block diagram of a network device in a possible implementation according to an embodiment of this application.

### DESCRIPTION OF EMBODIMENTS

To make the objectives, technical solutions, and advantages of this application clearer, the following further describes this application in detail with reference to the accompanying drawings. Specific operation methods, function descriptions, and the like in method embodiments may also be applied to apparatus embodiments or system embodiments.

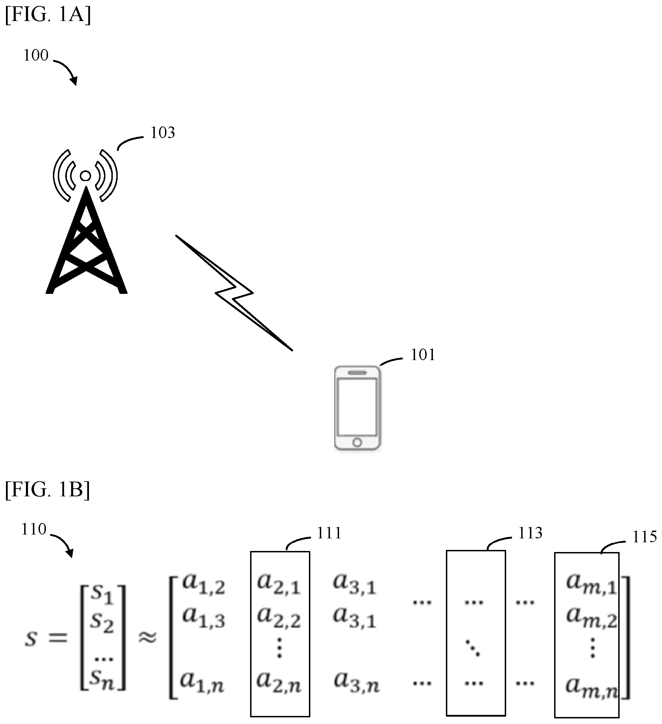

FIG. 1A shows a communication system 100 in which embodiments of this application may be implemented. As shown in FIG. 1A, the communication system 100 may include a terminal device 101 and a network device 103, and the terminal device 101 and the network device 103 are connected in a wireless manner. In some embodiments, the terminal device 101 and the network device 103 may be connected in a wired manner. In some embodiments, one or both of the terminal device 101 and the network device 103 may be used as a data processing apparatus (for example, a first device (data compression apparatus) or a second device (data decompression apparatus)), and may be configured to implement a data processing method (for example, a data compression method or a data decompression method) in various embodiments described in this specification. However, embodiments of this disclosure are not limited thereto. The data processing method in various embodiments described in this specification may also be implemented by any other communication device or data processing device.

As described above, for compression of high-dimensional vector data, transform domain compression based on dictionary learning (referred to as "dictionary compression" for short) is a highly effective compression method. However, dictionary compression is highly complex, which is not conducive to implementation on a terminal device with a poor computing capability. However, implementing dictionary compression on a network device adversely affects multi-channel concurrency and system capacity expansion. However, such a problem also exists when dictionary compression is used in other systems. A main procedure of dictionary compression may be illustrated by using a procedure 110 in FIG. 1B.

It is assumed that to-be-compressed original data is represented by using a vector S. The vector S may be represented as a linear combination of several vectors in a group of dictionaries by using dictionary compression. Herein, a three-vector combination is used as an example, that is, three vectors are selected from a given dictionary, so that a linear combination of the three vectors can be used to best approximate an original signal s ≈ *c*_{*i*1} · *a*_{*i*1} + *c*_{*i*2} · *a*_{*i*2} + *c*_{*i*3} *· a*_{*i*3}*.* An optimal approximation solution may be obtained by resolving the following optimization problem: $\left\{{i}_{1}, {i}_{2}, {i}_{3}, {c}_{{i}_{1}}, {c}_{{i}_{2}}, {c}_{{i}_{3}}\right\} = {argmax}_{\begin{matrix}1 \leq {i}_{1} , {i}_{2} , {i}_{3} \leq m \\ {c}_{{i}_{1}} , {c}_{{i}_{2}} , {c}_{{i}_{3}}\end{matrix}} d \left(s, {\sum }_{k = 1}^{3} {c}_{{i}_{k}} ⋅ {a}_{{i}_{k}}\right)$, where i is a subscript of a column selected from the dictionary, for example, columns indicated by 111, 113, and 115 in FIG. 1B, and *c*_{*i*1}*,c*_{*i*2}*,c*_{*i*3} are corresponding linear combination coefficients. After obtaining {_{*i*1}*, i*₂*, i*₃*, c*_{*i*1}*, c*_{*i*2}*, c*_{*i*3}}, a data decompression apparatus may perform decompression by using s ≈ *c*_{*i*1} · *a*_{*i*1} + *c*_{*i*2} *· a*_{*i*2} + *c*_{*i*3} · *a*_{*i*3}*.*

The dictionary compression solution is widely applicable. Common transform domain compression may be considered as a compression solution using a fixed dictionary (for example, fixed as an FFT matrix, a wavelet transform matrix, or the like). For data that cannot achieve good compression effect by using the common FFT matrix or wavelet transform, for example, a dictionary matrix A in dictionary compression can be obtained by resolving a dictionary learning problem, to achieve optimal compression effect. Dictionary compression may be used in a plurality of scenarios of native air interface data compression, for example, point cloud data compression, artificial intelligence (Artificial Intelligence, AI) model data compression, channel state information (Channel State Information, CSI) compression, and the like.

A main problem of applying dictionary compression to a scenario such as native air interface data compression is that complexity is high, making it unsuitable implementation on a terminal device. First, the optimization problem that needs to be resolved for dictionary compression is highly complex. In addition, for general data, obtaining and updating of a dictionary requires resolving the dictionary learning problem, and complexity of resolving the problems is also high. Moreover, the dictionary itself needs to occupy large storage space. In addition, compression effect of dictionary compression is good only when a source has a specific structure. For some non-structured data, for example, data whose elements are independent and identically distributed (Independent and Identically Distributed, iid), it is difficult to find a group of effective dictionaries to represent an original signal in a manner such as a sparse manner. In this case, the dictionary compression solution fails. Therefore, a data compression method with low complexity is urgently needed.

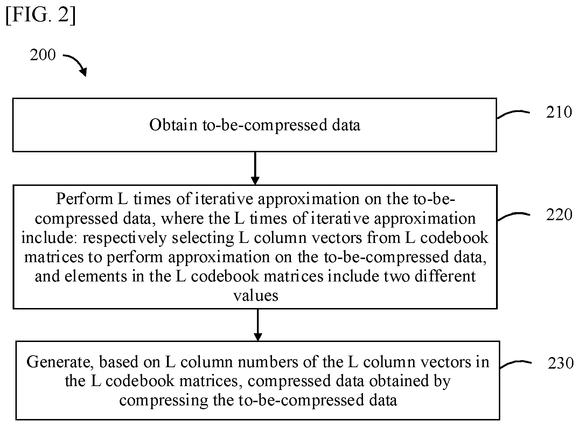

In view of this, embodiments of this application provide a technical solution for data compression, which can provide a lossy compression solution with lower complexity than dictionary learning-based compression. In some embodiments of the data compression solution, an original signal may be approximated by using a small codebook, to reduce search and storage overheads. In addition, a multiplication operation may be converted into an addition operation by using a codebook of ±1, thereby further reducing calculation and storage overheads. Further, a same codebook matrix may be used for each time of iteration (for example, a residual vector may be transformed), or may be obtained by transforming a same matrix, thereby further reducing storage overheads. Some embodiments of this disclosure are applicable to compression of any high-dimensional vector data, for example, can achieve better effect than dictionary compression and scalar quantization in compression of non-structured source data, and have lower complexity than dictionary compression, which facilitates hardware implementation. The technical solutions may be oriented to, for example, a future wireless communication system with a sensing function, such as a next generation cellular system or a short-range wireless communication system (such as Wi-Fi or UWB), and may be widely used in a terminal device or a network side device in a future wireless communication scenario. The following further describes embodiments of this disclosure with reference to FIG. 2 to FIG. 21.

FIG. 2 is a flowchart of a data compression method according to an embodiment of this application. A procedure 200 in FIG. 2 may be performed in a first device (data compression apparatus). In some embodiments, the first device (data compression apparatus) may be, for example, the terminal device 101 or the network device 103 in FIG. 1A, or any other communication device or data processing device that is not shown in FIG. 1A. The "first device" may refer to the first device itself (for example, a terminal device or a network device), may be a component (for example, a processor, a chip, or a chip system) in the first device, or may be a logical module or software that can implement all or a part of functions of the first device.

In the procedure 200, in 210, the data compression apparatus obtains to-be-compressed data. In 220, the data compression apparatus performs L times of iterative approximation on the to-be-compressed data, where the L times of iterative approximation include: respectively selecting L column vectors from L codebook matrices to perform approximation on the to-be-compressed data, and elements in the L codebook matrices include two different values. In 230, the data compression apparatus generates, based on L column numbers of the L column vectors in the L codebook matrices, compressed data obtained by compressing the to-be-compressed data. In this embodiment of this disclosure, the data compression apparatus may alternatively generate, based on the L column vectors, the compressed data obtained by compressing the to-be-compressed data.

In this embodiment of this disclosure, the two different values may be +P and -Q, and absolute values of +P and -Q are different, so that fitting is performed on the to-be-compressed data whose mean is not 0. The two different values may be +P and -P, and absolute values of +P and -P are the same, for example, +2 and -2, or +4 and -4. This can save storage space. For 2 to the power of n, a multiplication operation may be replaced with a bit shift operation, thereby saving computational operations.

In this embodiment of this disclosure, the two different values may be +1 and -1, so that a multiplication operation is further simplified into an addition or subtraction operation, thereby further saving computational operations and reducing storage overheads.

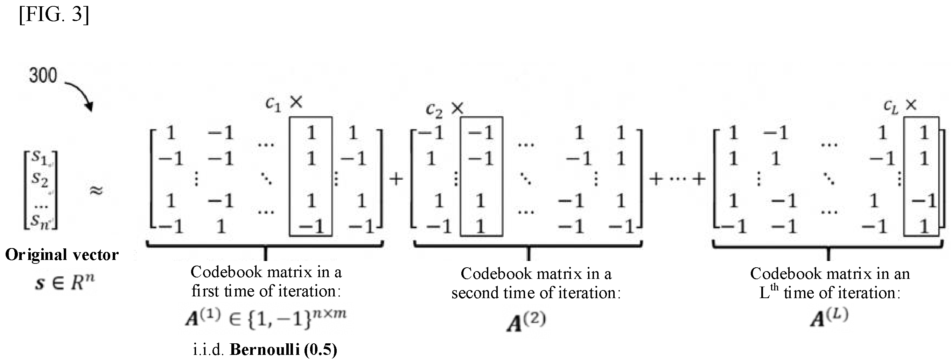

The procedure in FIG. 2 is an improved solution in a dictionary compression framework. Specific steps may be described in FIG. 3. The solution is characterized as follows: An original signal is approximated by using a small codebook, thereby reducing search and storage overheads; and a multiplication operation is converted into an addition or subtraction operation by using a codebook of ±1, thereby further reducing calculation and storage overheads. In some embodiments, a same codebook matrix is used for each time of iteration, and a residual vector of each time of iteration needs to be transformed. In some embodiments, a codebook matrix of each time of iteration may be obtained by transforming a same matrix. In the foregoing implementation, storage overheads can be further reduced.

In FIG. 3, a residual obtained through a previous time of iteration is approximated in each time of iteration. An objective of each time of iteration is to select, from a matrix A⁽ⁱ⁾, a column that has maximum correlation with a to-be-approximated vector: ${j}^{\left(i\right)} = {max}_{j : 1 \leq j \leq m} \left〈{A}_{j}^{\left(i\right)}, \frac{{r}_{i - 1}}{\left‖{r}_{i - 1}\right‖}\right〉$ , and then multiply the column vector by a fixed coefficient *cᵢ* to perform approximation on a residual *r*_{*i*-1} obtained through a previous time of iteration, to obtain a residual ${r}_{i} = {r}_{i - 1} - {c}_{i} {A}_{{j}^{\left(i\right)}}^{\left(i\right)}$ of a current time of iteration and use the residual ${r}_{i} = {r}_{i - 1} - {c}_{i} {A}_{{j}^{\left(i\right)}}^{\left(i\right)}$ in a next time of iteration. For example, for a first time of iteration, the to-be-approximated vector may be an original vector S. In a codebook matrix A⁽¹⁾, a *j*^{(1)th} column is selected, that is, ${A}_{{j}^{\left(1\right)}}^{\left(1\right)}$*,* and a residual ${r}_{1} = S - {c}_{1} {A}_{{j}^{\left(1\right)}}^{\left(1\right)}$ is obtained. For a second time of iteration, the residual *r*₁ is used as the to-be-approximated vector. In a codebook matrix A⁽²⁾, a *j*^{(2) th} column is selected, that is, ${A}_{{j}^{\left(2\right)}}^{\left(2\right)}$*,* and a residual ${r}_{2} = {r}_{1} - {c}_{2} {A}_{{j}^{\left(2\right)}}^{\left(2\right)}$ is obtained..... In this way, L times of iteration are performed. In a codebook matrix such as A⁽¹⁾, 1 and -1 may satisfy Bernoulli (Bernoulli) distribution with a probability of 0.5. In embodiments of this disclosure, a result obtained by compressing an original signal S may be a series of subscripts: { *j*⁽¹⁾ *, j*⁽²⁾ , ...}. After obtaining these subscripts, a data decompression apparatus may use a linear combination $\hat{s} = {\sum }_{i = 1}^{L} {c}_{i} {A}_{{j}^{\left(i\right)}}^{\left(i\right)}$ as a decompression result to perform approximation on the original vector S. In this embodiment of this disclosure, a coefficient {*cᵢ*} in the linear combination may be agreed on in advance by the data compression apparatus and the data decompression apparatus. Therefore, the coefficient {*cᵢ*} may not need to be explicitly sent from the data compression apparatus to the data decompression apparatus, thereby reducing signaling transmitted between the data compression apparatus and the data decompression apparatus and simplifying implementation. In this embodiment of this disclosure, there may be no excessive requirement on a matrix *A*^{(*l*)} in an iteration process, as long as a quantity of ±1 elements in the matrix A^{(*l*)} is basically equal in statistics, and column vectors ${A}_{{j}^{\left(i\right)}}^{\left(i\right)}$ and *r*_{*i*-1} of the matrix in each time of iteration are as statistically independent as possible. This simplifies implementation and improves execution efficiency. In subsequent embodiments of this disclosure, a codebook matrix design, a codebook and a residual transformation process in iteration, selection of a coefficient c, and performance analysis are described.

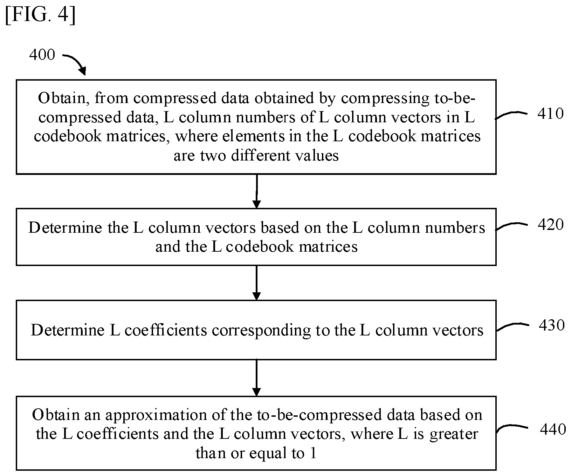

FIG. 4 is a flowchart of a data decompression method according to an embodiment of this application. A procedure 400 in FIG. 4 may be performed in a data decompression apparatus. In some embodiments, the data decompression apparatus may be, for example, the terminal device 101 or the network device 103 in FIG. 1A, or any other communication device or data processing device that is not shown in FIG. 1A.

In 410, the data decompression apparatus obtains, from compressed data obtained by compressing to-be-compressed data, L column numbers of L column vectors in L codebook matrices, where elements in the L codebook matrices are two different values. In 420, the data decompression apparatus determines the L column vectors based on the L column numbers and the L codebook matrices. In 430, the data decompression apparatus determines L coefficients corresponding to the L column vectors. In 440, the data decompression apparatus obtains an approximation of the to-be-compressed data based on the L coefficients and the L column vectors, where L is greater than or equal to 1. In this way, original to-be-compressed data may be approximated and fitted, thereby reducing a calculation amount and improving computational efficiency.

In this embodiment of this disclosure, the two different values may be +P and -Q, and absolute values of +P and -Q are different, so that fitting is performed on the to-be-compressed data whose mean is not 0. The two different values may be +P and -P, and absolute values of +P and -P are the same, for example, +2 and -2, or +4 and -4. This can save storage space. For 2 to the power of n, a multiplication operation may be replaced with a bit shift operation, thereby saving computational operations.

In this embodiment of this disclosure, the two different values may be +1 and -1, so that a multiplication operation is further simplified into an addition or subtraction operation, thereby further saving computational operations and reducing storage overheads.

Then, a specific process of data compression is described. In each time of iteration, it is necessary to ensure that column vectors ${A}_{j}^{\left(i\right)}$ and *r*_{*i*-1} of a small matrix are statistically independent as much as possible. In an implementation, a matrix is randomly generated for iteration based on Bernoulli distribution (a probability of ±1 is 0.5) in each time of iteration. In this implementation, unnecessary storage space may be wasted, and generating a random number may also be time-consuming. This is not conducive to high-speed implementation of hardware. In subsequent embodiments, all times of iteration may be implemented by using a same codebook matrix or by transforming a same codebook matrix, thereby simplifying implementation and improving calculation efficiency while ensuring that performance is not affected.

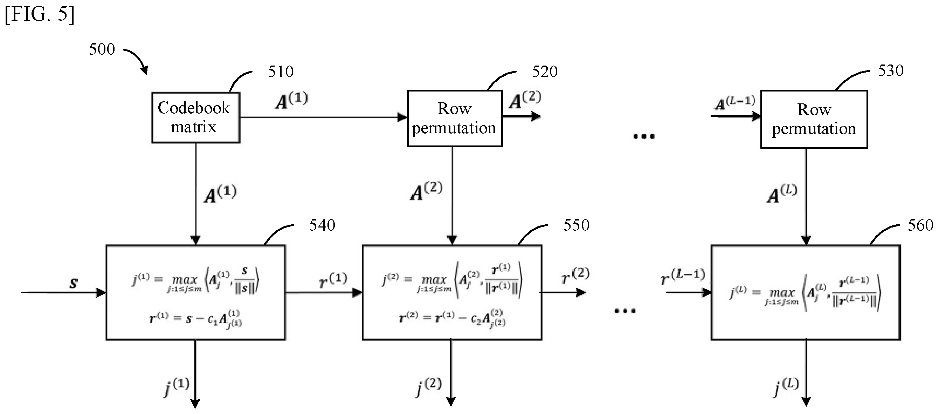

In embodiments, a first codebook matrix with ±1 elements is generated only in a first time of iteration. The first codebook matrix may be randomly generated during compression (a random number seed needs to be shared by the data compression apparatus and the data decompression apparatus), or may be a ±1 matrix configured in advance. This provides more options for generating the first codebook matrix, and improves flexibility. A codebook matrix used in each time of iteration of subsequent iterative approximation is obtained by performing a row permutation on a first matrix. A main procedure is shown in FIG. 5.

In a procedure 500, a first codebook matrix A⁽¹⁾ is obtained in 510; and in 540, for the original vector S, a j^{(1)th} column ${A}_{{j}^{\left(1\right)}}^{\left(1\right)}$ in A⁽¹⁾ and a residual r⁽¹⁾ are obtained by taking a maximum value from inner product operations, where "< >" is the inner product operation. In this case, a vector ${A}_{{j}^{\left(1\right)}}^{\left(1\right)}$ selected from all columns of A⁽¹⁾ has maximum correlation with the original vector S. Subsequently, a product ${c}_{1} {A}_{{j}^{\left(1\right)}}^{\left(1\right)}$ of a coefficient *c*₁ and ${A}_{{j}^{\left(1\right)}}^{\left(1\right)}$ may be used to perform approximation on the original vector S. In 520, row transformation is performed on the first codebook matrix A⁽¹⁾ to obtain a second codebook matrix A⁽²⁾. In 550, for the residual r⁽¹⁾, a j^{(2)th} column ${A}_{{j}^{\left(2\right)}}^{\left(2\right)}$ in A⁽²⁾ is obtained by taking a maximum value from inner product operations, and a residual r⁽²⁾ is obtained. In this case, a vector ${A}_{{j}^{\left(2\right)}}^{\left(2\right)}$ selected from all columns of A⁽²⁾ has maximum correlation with the residual r⁽¹⁾. A product ${c}_{2} {A}_{{j}^{\left(2\right)}}^{\left(2\right)}$ of a coefficient *c*₂ and ${A}_{{j}^{\left(2\right)}}^{\left(2\right)}$ is used to perform approximation on the residual r⁽¹⁾. In this way, an L^{th} codebook matrix A^{(L)} is obtained after L times of iteration, and a vector ${A}_{{j}^{\left(L\right)}}^{\left(L\right)}$ in the L^{th} codebook matrix A^{(L)} is selected. The quantity L of iteration times may be a preset value, or may be determined by comparing a residual r⁽ⁱ⁾ of an i^{th} time of iteration with a predetermined threshold. Finally, column numbers j⁽¹⁾ to j^{(L)} are selected from the first codebook matrix to the L^{th} codebook matrix, and all codebook matrices A⁽¹⁾ to A^{(L)} do not need to be sent to the data decompression apparatus, thereby reducing storage space and simplifying computational operations.

A row permutation used to iteratively generate A^{(L)} from the first codebook matrix A⁽¹⁾ may be a random permutation or a simple row rotation. The random permutation can obtain better randomness between matrices, and the row rotation can simplify a process of obtaining subsequent codebook matrices and simplify calculation. In embodiments of this disclosure, a permutation mode indication may be added to indicate one of the two permutation manners, to synchronize the data compression apparatus with the data decompression apparatus. If the row rotation is used, whether to use a forward cyclic shift or a backward cyclic shift and a corresponding shift amount may be configured in advance. If the random row permutation is used, the data compression apparatus may indicate whether the data decompression apparatus reuses a same random row permutation manner in each time of iteration or randomly generates a new row permutation manner in each time of iteration. The new row permutation manner randomly generated in each time of iteration may be separately determined in iteration. The random row permutation may reuse a random number seed of a codebook matrix, or use another shared random number seed of a random permutation. This provides more options and improves flexibility.

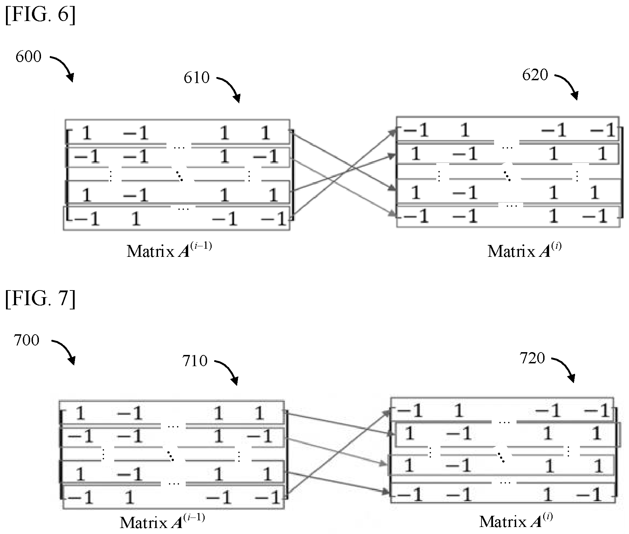

In embodiments of this disclosure, a specific random row permutation process is shown in FIG. 6, and a simple forward cyclic shift or row rotation process is shown in FIG. 7. In FIG. 6, the random row permutation is performed on a codebook matrix A⁽ⁱ⁻¹⁾ 610, to obtain a codebook matrix A⁽ⁱ⁾ 620. In FIG. 7, the forward cyclic shift is performed on a codebook matrix A⁽ⁱ⁻¹⁾ 710 to obtain a codebook matrix A⁽ⁱ⁾ 720.

In embodiments of this disclosure, the data decompression apparatus may synchronously perform iteration with the data compression apparatus by using a same codebook matrix, and then use $\hat{s} = {\sum }_{i = 1}^{L} {c}_{i} {A}_{{j}^{\left(i\right)}}^{\left(i\right)}$ as an output result of decompression.

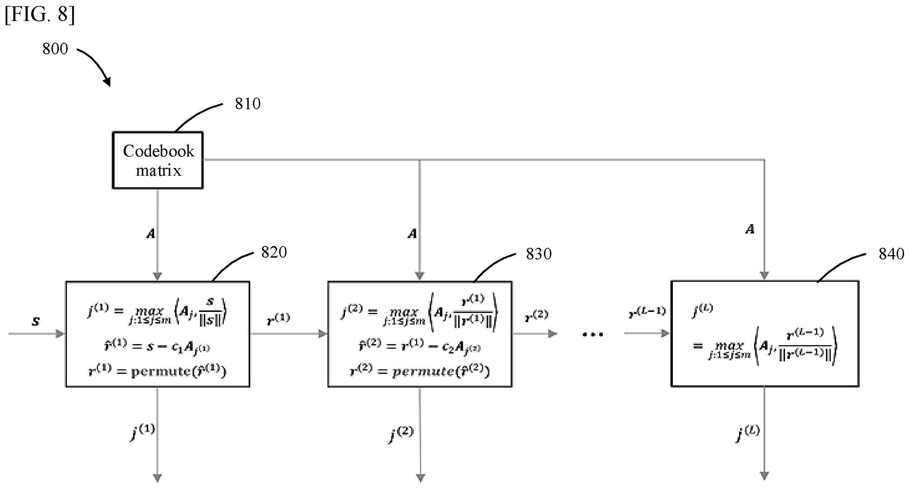

In the foregoing embodiments, behavior of performing the row permutation on the codebook matrix in each time of iteration is mathematically equivalent to performing an element permutation on a residual vector obtained in each time of iteration. In embodiments of this disclosure, permuting an element of a vector is simpler than permuting a row of a matrix. A same codebook matrix is used in each time of iteration, and a permutation needs to be performed on a residual vector obtained in each time of iterative approximation, to further reduce computational overheads. A specific procedure is shown in FIG. 8.

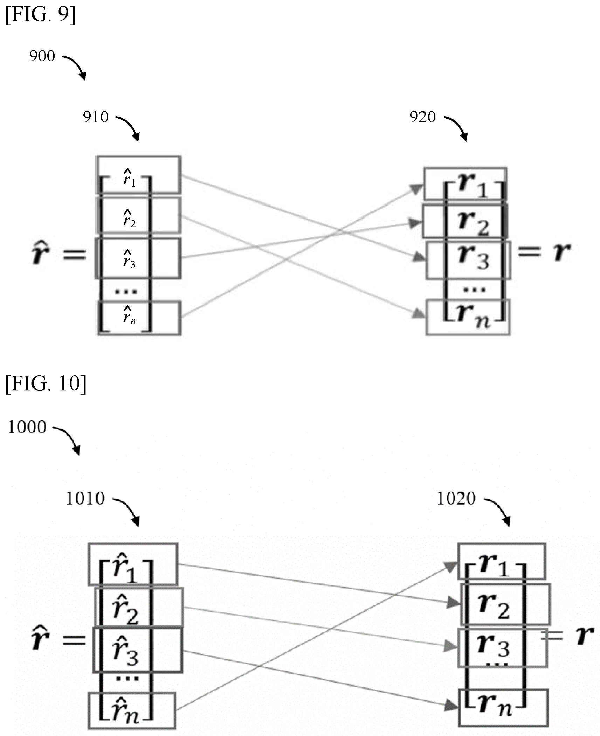

In embodiments of this disclosure, in a procedure 800, a codebook matrix A is obtained in 810. In 820, a j^{(1)th} column that is most similar to an original vector S is obtained from the codebook matrix A by using an inner product operation "< >", and a residual vector *r̂*⁽¹⁾ is obtained; and an element permutation (permute) is performed on the residual *r̂*⁽¹⁾, to obtain a residual vector *r*⁽¹⁾. In 830, a j^{(2)th} column that is most similar to the residual vector *r*⁽¹⁾ is obtained from the codebook matrix A, and a residual vector *r̂*⁽²⁾ is obtained; and an element permutation is performed on the residual *r̂*⁽²⁾, to obtain a residual vector *r*⁽²⁾. By analogy, in step 840, in an L^{th} time of iteration, a j^{(L)th} column that is most similar to a residual vector *r*^{(*L*-1)} is obtained from the codebook matrix A. In this way, an element permutation process of the residual vector is completed, and column numbers j⁽¹⁾, j⁽²⁾, ..., and j^{(L)} generated in each time of iteration are output. In embodiments of this disclosure, the element permutation of the residual vector may be implemented by using a random element permutation, or the element permutation of the residual vector may be implemented by using a cyclic shift. The cyclic shift may be a backward cyclic shift or a forward cyclic shift. In FIG. 9, the random element permutation is performed on a residual vector *r̂* 910, to obtain a residual vector r 920. In FIG. 10, the element cyclic shift is performed on a residual vector *r̂* 1010, to obtain a residual vector r 1020.

Different from the matrix row permutation, because the data compression apparatus performs a series of element permutations on the residual vector, a series of inverse permutation operations may be performed by a receiver or the data decompression apparatus in embodiments of this disclosure. For example, element permutation operations performed by the data compression apparatus on the residual vector before and after each time of iteration are sequentially denoted as: 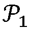 , 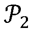 , 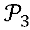 *, ...* 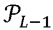 , and there are L times of iteration in total. An element permutation of the residual vector is not required in a last time of iteration. If corresponding element inverse permutation operations are denoted as: ${P}_{1}^{- 1} , {P}_{2}^{- 1} , … {P}_{L - 1}^{- 1}$ *,* it is equivalent to that the data compression apparatus performs the following series of operations and approximations: ${\hat{r}}^{\left(1\right)} = s - {c}_{1} {A}_{{j}^{\left(1\right)}}$ ${\hat{r}}^{\left(2\right)} = {P}_{1} \left({\hat{r}}^{\left(1\right)}\right) - {c}_{2} {A}_{{j}^{\left(2\right)}}$ ${\hat{r}}^{\left(3\right)} = {P}_{2} \left({\hat{r}}^{\left(2\right)}\right) - {c}_{3} {A}_{{j}^{\left(3\right)}}$ ${\hat{r}}^{\left(L-1\right)} = {P}_{L - 2} \left({\hat{r}}^{\left(L-2\right)}\right) - {c}_{L - 1} {A}_{{j}^{\left(L-1\right)}}$ $0 \approx {P}_{L - 1} \left({\hat{r}}^{\left(L-1\right)}\right) - {c}_{L} {A}_{{j}^{\left(L\right)}} .$

In this case, the data decompression apparatus may not simply restore original data by using a linear combination of a vector and a coefficient, but embed a corresponding element permutation operation into a decompression process. A final output result of the data decompression apparatus may be: $\begin{matrix}\hat{s} = {c}_{1} {A}_{{j}^{\left(1\right)}} + {P}_{1}^{- 1} \left({c}_{2}{A}_{{j}^{\left(2\right)}}\right) + {P}_{1}^{- 1} ∗ {P}_{2}^{- 1} \left({c}_{3}{A}_{{j}^{\left(3\right)}}\right) + \\ {P}_{1}^{- 1} ∗ {P}_{2}^{- 1} ∗ {P}_{3}^{- 1} \left({c}_{4}{A}_{{j}^{\left(4\right)}}\right) + ⋯ + {P}_{1}^{- 1} ∗ {P}_{2}^{- 1} ∗ … ∗ {P}_{L - 1}^{- 1} \left({c}_{L}{A}_{{j}^{\left(L\right)}}\right)\end{matrix}$

In this way, *c*₁*A*_{*j*(1)}, ${P}_{1}^{- 1} \left({c}_{2}{A}_{{j}^{\left(2\right)}}\right) , {P}_{1}^{- 1} ∗ {P}_{2}^{- 1} \left({c}_{3}{A}_{{j}^{\left(3\right)}}\right)$*,* and the like may be processed in parallel, thereby improving processing efficiency and reducing a decompression delay.

In embodiments of this disclosure, if the data compression apparatus uses a same element permutation manner for the residual vector in each time of iteration, 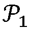 = 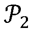 *=* 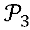 =...= 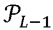 *,* and may be denoted as 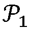 , an operation process of the data decompression apparatus may be further simplified as follows: $\begin{matrix}\hat{s} = {c}_{1} {A}_{{j}^{\left(1\right)}} + {P}_{1}^{- 1} \left({c}_{2}{A}_{{j}^{\left(2\right)}}\right) + {P}_{1}^{- 2} \left({c}_{3}{A}_{{j}^{\left(3\right)}}\right) + \\ {P}_{1}^{- 3} \left({c}_{4}{A}_{{j}^{\left(4\right)}}\right) + ⋯ + {P}_{1}^{- \left(L-1\right)} \left({c}_{L}{A}_{{j}^{\left(L\right)}}\right) .\end{matrix}$

In this way, calculation can be further simplified. In addition, operations such as ${P}_{1}^{- 2}$ and ${P}_{1}^{- 3}$ may be constructed as an overall single operation, instead of a cascading operation of a plurality of ${P}_{1}^{- 1}$ operations, thereby further simplifying calculation and reducing a decompression delay.

In embodiments of this disclosure, a coefficient *cᵢ* (1 ≤ *i* ≤ *L*) in an iterative approximation process may not be explicitly stored or sent, because the coefficient *cᵢ* (1 ≤ *i* ≤ *L*) may be calculated by the data compression apparatus and the data decompression apparatus after corresponding parameters are agreed on. The coefficient *cᵢ* is related to a dimension of to-be-compressed data S, a mean of to-be-compressed data S, a variance of to-be-compressed data S, and a dimension of a codebook matrix in each time of iteration. The data compression apparatus and the data decompression apparatus may only agree on these parameters, and do not need to explicitly send the coefficient *cᵢ* in each time of iteration. In this way, signaling transmission between the data compression apparatus and the data decompression apparatus can be simplified, and signaling resources can be saved. In embodiments of this disclosure, the coefficient *cᵢ* is described in detail as follows.

In embodiments of this disclosure, the original to-be-compressed data S may be approximated through continuous iteration. One requirement is that energy of a residual vector in each time of iteration becomes lower as iteration proceeds. In embodiments of this disclosure, it is expected that the energy of the residual vector exponentially attenuates with a quantity of iteration times. An expression of the coefficient *cᵢ* may be derived by using an inductive method, and the expression is as follows:

First, the variance of the original to-be-compressed data S (assuming that the mean is 0) is $\frac{{\left‖{r}_{0}\right‖}^{2}}{n} = {σ}^{2}$, and a compressed code rate may be obtained as follows: $\frac{L ⋅ log m}{n} = R$. In embodiments of this disclosure, it is expected that the energy of the residual vector in each time of iteration exponentially attenuates with the quantity of iteration times. It is assumed that a variance of a residual vector in an (i-1)^{th} time of iteration is $\frac{{\left‖{r}_{i - 1}\right‖}^{2}}{n} = {σ}^{2} {q}^{i - 1}$. An objective of embodiments of this disclosure is to select a proper coefficient *cᵢ*, and enable a residual vector after an i^{th} time of iteration to satisfy $\frac{{\left‖{r}_{i}\right‖}^{2}}{n} = {σ}^{2} {q}^{i}$ by performing the i^{th} iteration process: *rᵢ* = *r*_{*i*-1} *- cᵢA*_{*j*(*i*)} (where ${j}^{\left(i\right)} = {max}_{j : 1 \leq j \leq m} \left〈{A}_{j}^{\left(i\right)}, \frac{{r}_{i - 1}}{\left‖{r}_{i - 1}\right‖}\right〉$) in embodiments. This is valid in an asymptotic sense, and a derivation process is as follows:

*rᵢ = r*_{*i-*1} *- cᵢA*_{*j*(*i*)} may be transformed to obtain $\frac{{\left‖{r}_{i}\right‖}^{2}}{n} = \frac{{\left‖{r}_{i - 1}\right‖}^{2}}{n} + {c}_{i}^{2} \frac{{\left‖{A}_{{j}^{\left(i\right)}}\right‖}^{2}}{n} - \frac{2 {c}_{i} \left‖{r}_{i - 1}\right‖}{n} \left〈{A}_{{j}^{\left(i\right)}}, \frac{{r}_{i - 1}}{\left‖{r}_{i - 1}\right‖}\right〉$ . This transformation may be an operation of performing a modulo square operation on both sides of the equation and then dividing a result by N. According to the central limit theorem (elements of a vector *r*_{*i*-1} are independent and identically distributed as much as possible), $\left〈{A}_{{j}^{\left(i\right)}}, \frac{{r}_{i - 1}}{\left‖{r}_{i - 1}\right‖}\right〉$ may be a maximum value of m independent standard Gaussian distribution random variables. Therefore, asymptotically, $\left〈{A}_{{j}^{\left(i\right)}}, \frac{{r}_{i - 1}}{\left‖{r}_{i - 1}\right‖}\right〉 = \sqrt{2 logm}$ . The following may be obtained by combining these results: $\frac{{\left‖{r}_{i}\right‖}^{2}}{n} = {σ}^{2} {q}^{i - 1} + {c}_{i}^{2} - \frac{2 {c}_{i} σ \sqrt{{q}^{i - 1}}}{\sqrt{n}} \sqrt{2 log m}$ *.* In embodiments of this disclosure, because it is expected to obtain $\frac{{\left‖{r}_{i}\right‖}^{2}}{n} = {σ}^{2} {q}^{i}$, a quadratic equation with one unknown may be obtained through combination: ${\left(\frac{{c}_{i}}{σ}\right)}^{2} - 2 \sqrt{{q}^{i - 1}} \sqrt{\frac{2 log m}{n}} \left(\frac{{c}_{i}}{σ}\right) + {q}^{i - 1} - {q}^{i} = 0$. It can be obtained from the foregoing derivation that, as long as a value of *cᵢ* is a solution of the quadratic equation with one unknown, $\frac{{\left‖{r}_{i}\right‖}^{2}}{n} = {σ}^{2} {q}^{i}$ is valid in an asymptotic sense. The foregoing quadratic equation with one unknown may be resolved to obtain ${c}_{i} = σ \sqrt{{q}^{i - 1}} \left(\sqrt{\frac{2 log m}{n}}\pm \sqrt{\frac{2 log m}{n} - \left(1-q\right)}\right)$*,* where an attenuation coefficient q needs to satisfy the following constraint: $q \geq 1 - \frac{2 log m}{n}$. q represents an attenuation rate of energy of a residual vector. Therefore, a smaller value of q is better when the constraint is satisfied. Therefore, theoretically, $q * = 1 - \frac{2 log m}{n}$ is optimal (small). In this case, ${c}_{i} = σ \sqrt{\frac{2 log m}{n}} \sqrt{{\left(1-\frac{2 log m}{n}\right)}^{i - 1}}$. In this way, the coefficient *cᵢ* may be locally calculated by both the data compression apparatus and the data decompression apparatus, and signaling transmission is not required, thereby saving signaling resources and simplifying implementation.

In embodiments of this disclosure, analysis of the optimal value q* of q is asymptotically valid when n and m tend to infinity. However, for finite n and m, the foregoing parameter selection may not be optimal. In this case, the optimal q may be searched in an interval near the theoretically optimal q*, and q with best actual compression effect is selected. It can be learned that, in embodiments of this disclosure, the data compression apparatus and the data decompression apparatus may agree on parameters n (the dimension of the compressed data S, or a row quantity of a codebook matrix), m (a column quantity of the codebook matrix), and q, and calculate the coefficient *cᵢ* based on n, m, and q. Because the optimal q is irrelevant to the quantity L of iteration times, the data compression apparatus and the data decompression apparatus only need to agree on the parameters n and m. The data compression apparatus and the data decompression apparatus may further calculate the coefficient *cᵢ* based on the variance *σ* of the exchanged original data (optionally, *c*₁ may be exchanged, instead of *σ*). In embodiments of this disclosure, the original data S may be decentralized, and the data compression apparatus and the data decompression apparatus may further exchange the mean ***µ***. In this way, adaptability to different to-be-compressed data can be improved.

An application scenario of embodiments of this disclosure may be, for example, compression of native air interface data in a communication system. The data compression apparatus and the data decompression apparatus may exchange with each other over the air interface. Therefore, air interface signaling may be affected. The following describes signaling exchanged over the air interface in embodiments of this disclosure. First, the data compression apparatus needs to send the compressed data to the data decompression apparatus. The data mainly includes: bit representation of a subscript of a column selected from an encoding matrix in an iteration process, and a mean *µ* of current data, a variance *σ* of the current data, or a value of c₁.

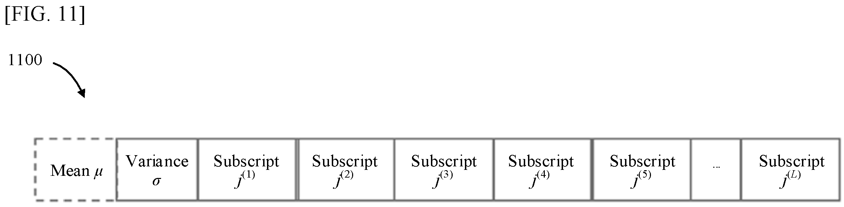

FIG. 11 is a diagram of a data part exchanged between the compression apparatus and the decompression apparatus according to an embodiment of this application. A data part 1100 exchanged between the compression apparatus and the decompression apparatus includes the mean *µ* of the original data S, the variance *σ* of the original data S, and a number or a subscript j^{(I)} of a column selected from an encoding matrix in an iteration process.

In embodiments of this disclosure, the data compression apparatus and the data decompression apparatus may perform the following configuration, or the data compression apparatus may indicate the following to the data decompression apparatus.

The data compression apparatus and the data decompression apparatus may configure, or the data compression apparatus may indicate, to the data decompression apparatus, a compression manner and a compression parameter of the mean *µ*, the variance *σ*, or *c*₁. The compression manner may be represented by a floating-point number with specific precision, for example, half precision (16 bits), single precision (32 bits), or double precision (64 bits). The compression manner may also use uniform scalar quantization with a fixed quantity of bits (p bits). In this case, a size of a quantization interval may be configured, and a value beyond the interval may be truncated or processed in another manner. For example, in some specific scenarios in which the mean *µ* is always 0, the compression manner may also be configured as skipping sending the mean. In this way, the data compression apparatus efficiently obtains the compressed data, and transmits the compressed data to the data decompression apparatus for data decompression and restoration.

The data compression apparatus and the data decompression apparatus may configure, or the data compression apparatus may indicate, to the data decompression apparatus, the following compression parameters: a dimension n of the to-be-compressed data and a column quantity m of the codebook matrix. The dimension n of the to-be-compressed data may be implicitly indicated by using air interface signaling, or may be explicitly indicated. All possible sets of the column quantity m of the codebook matrix may be preconfigured, and then one of the values is activated based on a value of n and an actual situation. Generally, m≥n. Optionally, the error attenuation coefficient q may also be configured. In this case, corresponding to a case of a non-optimal q, the optimal $q * = 1 - \frac{2 logm}{n}$ does not need to be exchanged. In this way, the data compression apparatus and the data decompression apparatus are synchronized.

In embodiments of this disclosure, the data compression apparatus and the data decompression apparatus may configure a codebook matrix generation manner, or the data compression apparatus may indicate, to the data decompression apparatus, a randomly generated or preconfigured codebook matrix. If the codebook matrix is generated randomly, a random number seed needs to be configured. In this way, the data compression apparatus and the data decompression apparatus are synchronized.

In embodiments of this disclosure, optionally, mode selection may be performed between two modes: a matrix row permutation and an element permutation of a residual vector. For example, the element permutation of the residual vector may be selected, and is simple to implement. Alternatively, the permutation mode of the residual vector may be fixedly selected, for example, a forward cyclic shift, and is simple to implement and saves computational resources.

In embodiments of this disclosure, the data compression apparatus and the data decompression apparatus may configure whether the element permutation of the residual vector is a random permutation, a simple rotation, or a cyclic shift. For example, the simple rotation or the cyclic shift, for example, a forward cyclic shift or a backward cyclic shift, may be preferentially selected, or this mode may be fixed, to facilitate implementation. If rotation is used, a forward cyclic shift or a backward cyclic shift and a shift amount may be configured. If the random permutation is selected, the data compression apparatus may indicate whether the data decompression apparatus reuses a same random permutation or randomly generates a new permutation in each time of iteration. The random permutation may reuse a random number seed of a codebook matrix, to simplify implementation; or a random number seed of a random permutation is additionally configured, to improve flexibility.

In embodiments of this disclosure, the to-be-compressed data is iteratively approximated, and approximation precision is increasingly higher as iteration proceeds. Therefore, embodiments of this disclosure have incremental compression and transmission capabilities, for example, performing two types of transmission: basic transmission and incremental transmission. The data compression apparatus uses results of previous several times of iteration as basic transmission, and the data decompression apparatus may decompress the results of basic transmission. If precision of the results does not meet a requirement, the data compression apparatus may be indicated to transmit results of subsequent several times of iteration as incremental data, and the data decompression apparatus may combine a basic transmission part and an incremental transmission part to obtain a decompression result with higher precision. In the basic transmission manner and the incremental transmission manner, flexibility of compression and decompression can be improved, and application scenarios with different error requirements can be adapted.

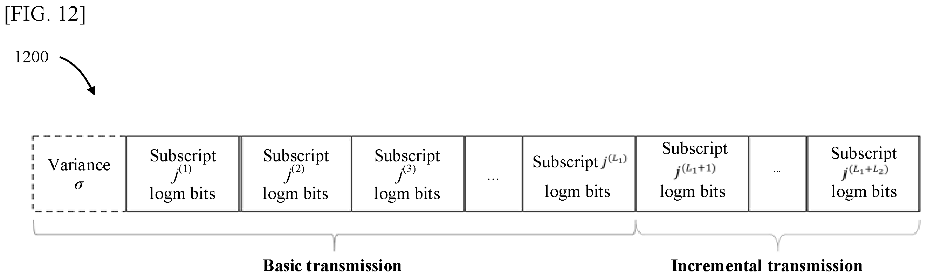

FIG. 12 is a diagram of basic transmission and incremental transmission according to an embodiment of this application. In an embodiment 1200 including basic transmission and incremental transmission, basic transmission data includes a variance *σ*, and subscripts j⁽¹⁾ to j^{(L1)} of column vectors selected from a codebook matrix. After the data decompression apparatus performs decompression based on the basic transmission data, and considers that precision of the decompressed data is insufficient, the data decompression apparatus may indicate the data compression apparatus to transmit incremental transmission data, that is, subscripts j^{(L1+1)} to j^{(L1+L2)} of column vectors selected from the codebook matrix. The subscripts j⁽¹⁾ to j^{(L1)} and j^{(L1+1)} to j^{(L1+L2)} of the column vectors may all use logm bits, to identify m columns of the codebook matrix.

In embodiments of this disclosure, data transmission over an air interface relates to resource application and scheduling, and is subsequently described with reference to resource scheduling signaling of the air interface.

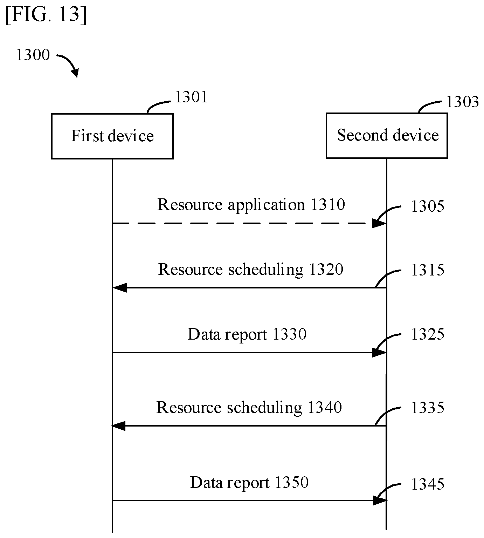

FIG. 13 is an interaction procedure of basic transmission and incremental transmission according to an embodiment of this application, and mainly relates to resource scheduling and data transmission of basic transmission and incremental transmission.

In an embodiment 1300, resource application and scheduling mainly relate to an indication of a quantity of iteration times, and specifically relate to resource application, resource scheduling, basic transmission, and incremental transmission. In some embodiments, the data compression apparatus or a first device 1301 may be the terminal device 101, and the data decompression apparatus or a second device 1302 may be the network device 103. In some other embodiments, the data compression apparatus or the first device 1301 may be the network device 103, and the data decompression apparatus or the second device 1302 may be the terminal device 101. In other embodiments, the data compression apparatus or the first device 1301 may be any appropriate communication device or data processing device, and the data decompression apparatus or the second device 1302 may be any appropriate another communication device or data processing device.

The first device 1301 may send (1305) a resource application 1310 to the second device 1303. The resource application 1310 may explicitly report a total quantity L' of iteration times, or may report a required resource in a buffer status report (Buffer Status Report, BSR). The second device 1303 sends (1315) resource scheduling 1320 to the first device 1301. The resource scheduling 1320 may indicate a quantity L1 of currently scheduled iteration times, and use 1 bit to indicate that current transmission is basic transmission. The first device 1301 sends (1325) a data report 1330 to the second device 1303. The data report 1330 may report variance data and results of previous L1 times of iterative compression together on a specified resource. The second device 1303 sends (1335) resource scheduling 1340 to the first device 1301. The resource scheduling 1340 may indicate a quantity L2 of currently scheduled iteration times, and use 1 bit to indicate that current transmission is incremental transmission. The first device 1301 sends (1345) a data report 1350 to the second device 1303. The data report 1350 may report results of L1+1 to L2 times of iterative compression on a specified resource. In embodiments of this disclosure, that the first device 1301 sends the resource application 1310 is optional. When the first device 1301 does not send the resource application 1310, the first device 1301 may also be allocated a proper resource through the resource scheduling 1320 and the resource scheduling 1340.

In embodiments of this disclosure, when the first device 1301 indicates L' in the resource application 1310, L' may be a total quantity of iteration times, and represents a volume of data that the first device 1301 expects to transmit, that is, a size of the resource application. L' may be implicitly indicated, for example, by using a BSR to report a data volume of to-be-compressed native data. A quantity that is of iteration times and that is actually sent depends on a size of a scheduled resource, and may be calculated by the first device 1301 by using the parameters m, n, and a quantity p of quantized variance bits. The resource may be scheduled once or scheduled for a plurality of times.

In embodiments of this disclosure, the second device 1303 indicates L1 or L2 in the resource scheduling 1320 or the resource scheduling 1340. In this case, L1 or L2 represents a size of a resource currently scheduled by the second device 1303. If the resource is used by the to-be-transmitted data alone, L1 or L2 does not need to be explicitly indicated, and the first device 1301 may calculate L1 or L2 by using the size of the resource and parameter values. If the to-be-transmitted data needs to multiplex the resource with other data, L1 or L2 may be explicitly indicated in, for example, a physical downlink control channel (physical Downlink Control Channel, PDCCH). A person of ordinary skill in the art may understand that L1 or L2 may alternatively be indicated by using a media access control control element (Media Access Control Control Element, MAC CE) or another signaling manner.

In embodiments of this disclosure, regardless of which manner is used, the first device 1301 or the second device 1303 needs to be capable of indicating whether incremental transmission needs to be performed, and may determine whether incremental transmission needs to be performed based on a current distortion size. For example, when applying for a resource, the first device 1301 declares, by using 1 bit, whether the resource is used for incremental transmission, or when scheduling a resource, the second device 1303 indicates, by using 1 bit, to the first device 1301 whether scheduling is used for incremental transmission. A person of ordinary skill in the art may understand that the first device 1301 or the data compression apparatus may be located in a network device, and the second device 1303 or the data decompression apparatus may be located in a terminal device. In this case, the resource application 1310 is not required, the resource scheduling 1320 and the resource scheduling 1340 are sent by the first device 1310 to the second device 1303, and the data report 1330 and the data report 1350 are updated to data delivery.

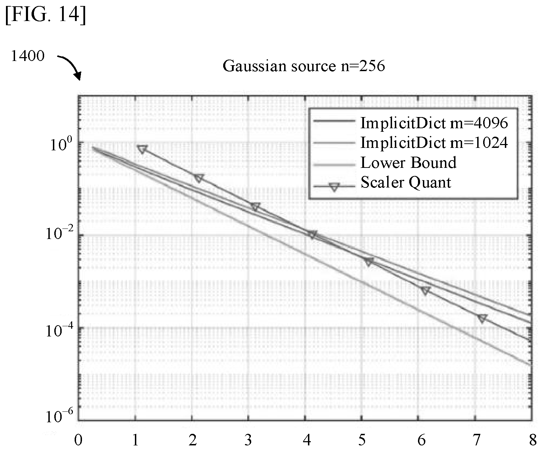

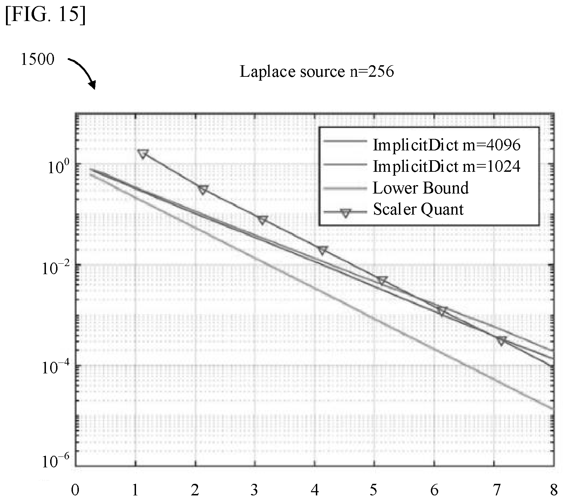

FIG. 14 and FIG. 15 are respectively a diagram of a simulation result of an independent and identically distributed Gaussian source and a diagram of a simulation result of an independent and identically distributed Laplace source according to embodiments of this application. In FIG. 14 and FIG. 15, a horizontal axis is a quantity of compressed bits/a column quantity n of a codebook matrix, and represents an average quantity of bits per element after compression, and a vertical axis is an error MSE. It can be learned from FIG. 14 and FIG. 15 that, embodiments of this disclosure achieve good compression effect on an independent and identically distributed iid source without a structure.

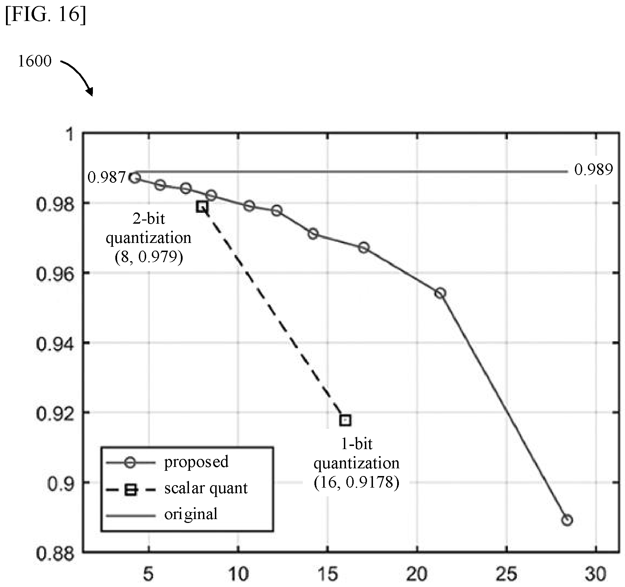

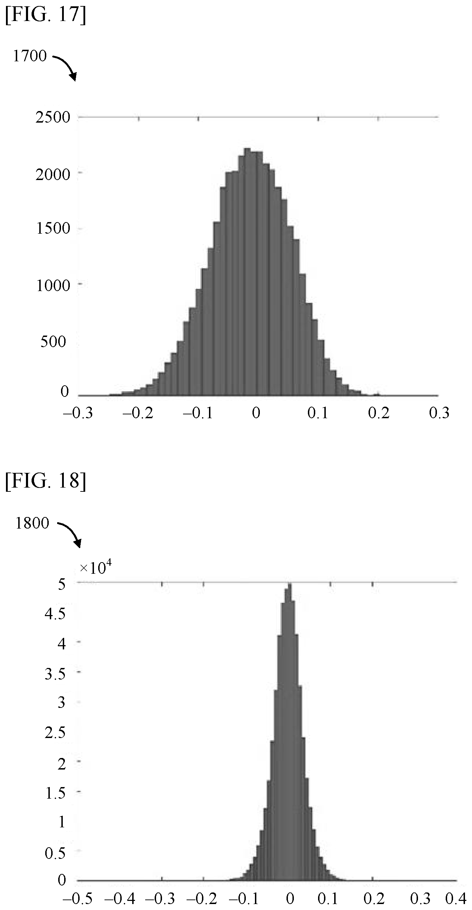

FIG. 16 is a diagram of test results on an artificial intelligence (Artificial Intelligence, AI) model according to an embodiment of this application. 1600 specifically shows test results of data compression on a small convolutional neural network model, and compression effect is good. FIG. 17 and FIG. 18 are diagrams of parameter distribution on an AI model according to embodiments of this application, and specifically show a statistical distribution histogram of parameters of the neural network model in FIG. 16. Data distribution 1700 of a convolutional layer is very close to Gaussian distribution, while distribution 1800 of a fully connected layer is very close to Laplace distribution.

In the foregoing embodiments provided in this application, the methods provided in embodiments of this application are separately described from perspectives of the network device, the terminal device, and interaction between the network device and the terminal device. To implement functions in the methods provided in embodiments of this application, the network device and the terminal device may include a hardware structure and/or a software module, and implement the functions in a form of the hardware structure, the software module, or a combination of the hardware structure and the software module. Whether a function in the foregoing functions is performed by using the hardware structure, the software module, or the combination of the hardware structure and the software module depends on particular applications and design constraints of the technical solutions.

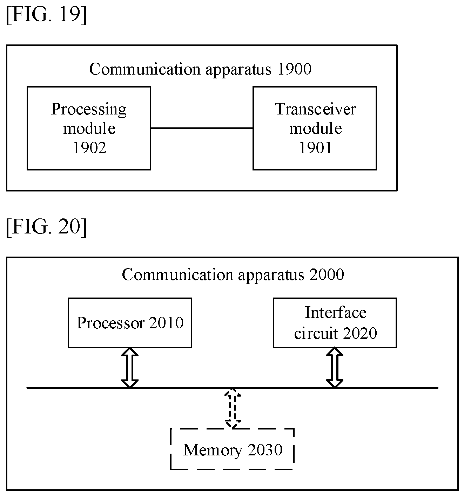

FIG. 19 and FIG. 20 are diagrams of possible structures of communication apparatuses according to embodiments of this application. The communication apparatuses may implement functions of the terminal device or the network device in the foregoing method embodiments. Therefore, the communication apparatuses can also implement beneficial effect of the foregoing method embodiments. In embodiments of this application, the communication apparatuses each may be the terminal device 101 shown in FIG. 1, the network device 103 shown in FIG. 1, or a module (for example, a chip) used in the terminal device or the network device.

As shown in FIG. 19, a communication apparatus 1900 includes a transceiver module 1901 and a processing module 1902. The communication apparatus 1900 may be configured to implement functions of the terminal device 101 or the network device 103 in the method embodiments shown in FIG. 2 and FIG. 4.

When the communication apparatus 1900 is configured to implement functions of the data compression apparatus in the method embodiment described in FIG. 2, the transceiver module 1901 is configured to obtain to-be-compressed data, and the processing module 1902 is configured to: perform L times of iterative approximation on the to-be-compressed data, where the L times of iterative approximation include: respectively selecting L column vectors from L codebook matrices to perform approximation on the to-be-compressed data, and elements in the L codebook matrices include two different values; and generate, based on L column numbers of L column vectors in the L codebook matrices, compressed data obtained by compressing the to-be-compressed data.

When the communication apparatus 1900 is configured to implement functions of the data decompression apparatus in the method embodiment described in FIG. 4, the transceiver module 1901 is configured to obtain, from compressed data obtained by compressing to-be-compressed data, L column numbers of L column vectors in L codebook matrices, where elements in the L codebook matrices are two different values, and the processing module 1902 is configured to: determine the L column vectors based on the L column numbers and the L codebook matrices; determine L coefficients corresponding to the L column vectors; and obtain an approximation of the to-be-compressed data based on the L coefficients and the L column vectors, where L is greater than or equal to 1.

As shown in FIG. 20, a communication apparatus 2000 includes a processor 2010 and an interface circuit 2020. The processor 2010 and the interface circuit 2020 are coupled to each other. It may be understood that the interface circuit 2020 may be a transceiver or an input/output interface. Optionally, the communication apparatus 2000 may further include a memory 2030, configured to store instructions executed by the processor 2010, store input data required by the processor 2010 to run the instructions, or store data generated after the processor 2010 runs instructions. In this embodiment of this disclosure, the memory 2030 may be integrated with the processor 2010, or may be disposed separately from the processor 2010.

When the communication apparatus 2000 is configured to implement the methods in the foregoing method embodiments, the processor 2010 is configured to perform functions of the processing module 1902, and the interface circuit 2020 is configured to perform functions of the transceiver module 1901.

When the communication apparatus is a chip used in a terminal device, the chip in the terminal device implements functions of the terminal device in the foregoing method embodiments. The chip in the terminal device receives information from another module (for example, a radio frequency module or an antenna) in the terminal device, where the information is sent by a network device to the terminal device. Alternatively, the chip in the terminal device sends information to another module (for example, a radio frequency module or an antenna) in the terminal device, where the information is sent by the terminal device to a network device.

When the communication apparatus is a chip used in a network device, the chip in the network device implements functions of the network device in the foregoing method embodiments. The chip in the network device receives information from another module (for example, a radio frequency module or an antenna) in the network device, where the information is sent by a terminal device to the network device. Alternatively, the chip in the network device sends information to another module (for example, a radio frequency module or an antenna) in the network device, where the information is sent by the network device to a terminal device.

It may be understood that, the processor in this embodiment of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general-purpose processor may be a microprocessor or any conventional processor.

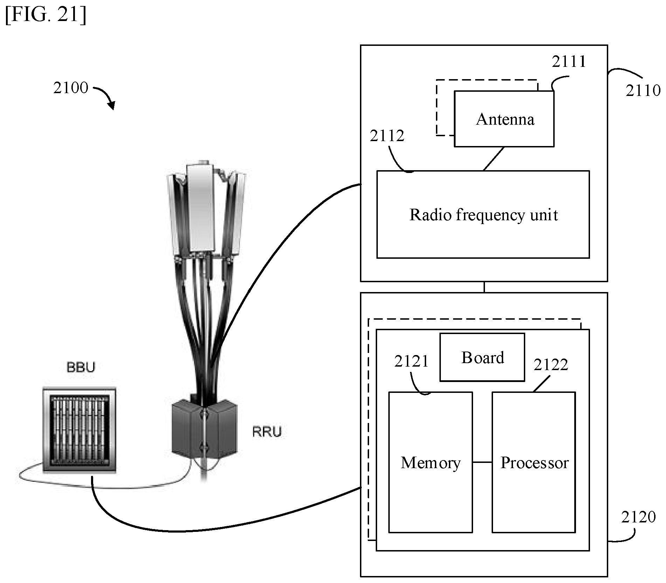

When the apparatus in this embodiment of this application is a network device, the apparatus may be shown in FIG. 21. The apparatus may include one or more radio frequency units, such as a remote radio unit (remote radio unit, RRU) 2110 and one or more baseband units (baseband unit, BBU) (which may also be referred to as digital units (digital unit, DU)) 2120. The RRU 2110 may be referred to as a transceiver module. The transceiver module may include a sending module and a receiving module, or the transceiver module may be a module that can implement sending and receiving functions. The transceiver module may correspond to the transceiver module 1901 shown in FIG. 19, that is, may perform actions performed by the transceiver module 1901. Optionally, the transceiver module may also be referred to as a transceiver device, a transceiver circuit, a transceiver, or the like, and may include at least one antenna 2111 and a radio frequency unit 2112. The RRU 2110 is mainly configured to: receive and send a radio frequency signal, and perform conversion between a radio frequency signal and a baseband signal. The BBU 2110 is mainly configured to: perform baseband processing, control a base station, and the like. The RRU 2110 and the BBU 2120 may be physically disposed together, or may be physically disposed separately, that is, in a distributed base station.

The BBU 2120 is a control center of the base station, may also be referred to as a processing module, may correspond to the processing module 1902 shown in FIG. 19, and is mainly configured to complete a baseband processing function, for example, channel coding, multiplexing, modulation, and spectrum spreading. In addition, the processing module may perform actions performed by the processing module 1902. For example, the BBU (processing module) may be configured to control the base station to perform operation procedures related to the network device in the foregoing method embodiments.

In an example, the BBU 2120 may include one or more boards. A plurality of boards may jointly support a radio access network (for example, an LTE network) of a single access standard, or may respectively support radio access networks (such as, an LTE network, a 5G network, or another network) of different access standards. The BBU 2120 further includes a memory 2121 and a processor 2122. The memory 2121 is configured to store necessary instructions and data. The processor 2122 is configured to control the base station to perform a necessary action, for example, is configured to control the base station to perform operation procedures related to the network device in the foregoing method embodiments. The memory 2121 and the processor 2122 may serve the one or more boards. In other words, a memory and a processor may be disposed on each board. Alternatively, the plurality of boards may share a same memory and a same processor. In addition, a necessary circuit may further be disposed on each board.

An embodiment of this application provides a communication system. The communication system may include the data compression apparatus in the embodiment shown in FIG. 2, for example, the terminal device, and include the data decompression apparatus in the embodiment shown in FIG. 4, for example, the network device. Optionally, the terminal device and the network device in the communication system may perform the communication method shown in FIG. 2 or FIG. 4.

An embodiment of this application further provides a circuit. The circuit may be coupled to a memory, and may be configured to perform procedures related to the terminal device or the network device in any one of the foregoing method embodiments. A chip system may include a chip, and may further include another component such as a memory or a transceiver.

It should be understood that the processor mentioned in embodiments of this application may be a CPU, or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or transistor logic device, a discrete hardware component, or the like. The general-purpose processor may be a microprocessor, or the processor may be any conventional processor or the like.

It may be understood that the memory mentioned in embodiments of this application may be a volatile memory or a non-volatile memory, or may include a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. Through example but not limitative description, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus dynamic random access memory (direct rambus RAM, DR RAM).

It should be noted that when the processor is a general-purpose processor, a DSP, an ASIC, an FPGA or another programmable logic device, a discrete gate or a transistor logic device, or a discrete hardware component, the memory (a storage module) is integrated into the processor.

It should be noted that the memory described in this specification is intended to include but is not limited to these memories and any memory of another proper type.

It should be understood that sequence numbers of the foregoing processes do not mean execution sequences in various embodiments of this application. The execution sequences of the processes should be determined based on functions and internal logic of the processes, and should not be construed as any limitation on the implementation processes of embodiments of this application.

It should be aware that, in combination with the examples described in embodiments disclosed in this specification, modules and algorithm steps can be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood that, for the purpose of convenient and brief description, for a specific working process of the foregoing system, apparatus, and module, refer to a corresponding process in the foregoing method embodiments. Details are not described herein again.

In the several embodiments provided in this application, it should be understood that the disclosed communication method and apparatus may be implemented in other manners. For example, the described apparatus embodiment is merely an example. For example, division into the modules is merely logical function division and may be other division in actual implementation. For example, a plurality of modules or components may be combined or integrated into another system, or some features may be ignored or not performed. In addition, the displayed or discussed mutual couplings or direct couplings or communication connections may be implemented by using some interfaces, and the indirect couplings or communication connections between the apparatuses or units may be implemented in electronic, mechanical, or other forms.

The modules described as separate parts may or may not be physically separate, and parts displayed as modules may or may not be physical modules, may be located in one position, or may be distributed on a plurality of network units. A part or all of the units may be selected based on actual requirements to achieve the objectives of the solutions of embodiments.

In addition, functional modules in embodiments of this application may be integrated into one processing module, each of the modules may exist alone physically, or two or more modules may be integrated into one module.

When the functions are implemented in a form of a software functional module and sold or used as independent products, the functions may be stored in a computer-readable storage medium. Based on such an understanding, the technical solutions of this application essentially, or the part contributing to the conventional technology, or a part of the technical solutions may be implemented in a form of a software product. The computer software product is stored in a storage medium and includes several instructions for instructing a computer device (which may be a personal computer, a server, or a network device) to perform all or a part of the steps of the methods described in embodiments of this application. The computer-readable storage medium may be any usable medium that can be accessed by a computer. The computer-readable storage medium includes, for example but not limited to: a random access memory (random access memory, RAM), a read-only memory (read-only memory, ROM), an electrically erasable programmable read-only memory (electrically erasable programmable read-only memory, EEPROM), a compact disc read-only memory (compact disc read-only memory, CD-ROM), a universal serial bus flash disk (universal serial bus flash disk), a removable hard disk or another optical disc storage, a disk storage medium or another magnetic storage device, or any other medium that can carry or store expected program code in a form of an instruction or a data structure and that can be accessed by a computer.

As used in this specification, the term "include" and similar terms should be understood as open inclusion, that is, "include but not limited to". The term "based on" should be understood as "at least partially based on". The term "one embodiment" or "this embodiment" should be understood as "at least one embodiment". Terms such as "first", "second", and the like may refer to different objects or a same object, and are merely used to distinguish between specified objects, but do not imply a specific spatial order, a time order, an importance order, or the like of the specified objects. In some embodiments, a value, a process, a selected item, a determined item, a device, an apparatus, a means, a part, a component, or the like is referred to as "optimal", "lowest", "highest", "minimum", "maximum", or the like. It should be understood that such a description is intended to indicate that a selection may be made among many available functional selections, and such a selection does not need to be better, lower, higher, smaller, larger, or otherwise preferred than other selections in other aspects or in all aspects. As used in this specification, the term "determining" may cover a variety of actions. For example, "determining" may include computing, calculating, processing, exporting, investigating, searching (for example, searching in a table, database, or another data structure), finding, and the like. In addition, "determining" may include receiving (for example, receiving information), accessing (for example, accessing data in a memory), and the like. In addition, "determining" may include parsing, selecting, choosing, establishing, and the like.

## Claims

1. A method, comprising:
obtaining to-be-compressed data;
performing L times of iterative approximation on the to-be-compressed data, wherein the L times of iterative approximation comprise: respectively selecting L column vectors from L codebook matrices to perform approximation on the to-be-compressed data, and elements in the L codebook matrices comprise two different values; and
generating, based on L column numbers of the L column vectors in the L codebook matrices, compressed data obtained by compressing the to-be-compressed data.

2. The method according to claim 1, wherein
the two different values comprise 1 and -1.

3. The method according to claim 1 or 2, wherein performing an i^{th} time of iterative approximation of the L times of iterative approximation comprises:
determining, based on a to-be-approximated vector, an i^{th} column vector in the L column vectors in an i^{th} codebook matrix in the L codebook matrices, wherein in the i^{th} time of iterative approximation, the to-be-approximated vector is determined based on a residual vector corresponding to an (i-1)^{th} time of iterative approximation, and in a first time of iterative approximation, the to-be-approximated vector is the to-be-compressed data, wherein L is greater than 1, i is less than or equal to L, and the residual vector corresponding to the (i-1)^{th} time of iterative approximation is an error in the (i-1)^{th} time of iterative approximation.

4. The method according to claim 3, wherein performing the i^{th} time of iterative approximation of the L times of iterative approximation further comprises:
approximating the to-be-approximated vector by using the i^{th} column vector and an i^{th} coefficient corresponding to the i^{th} column vector.

5. The method according to claim 3 or 4, wherein performing the i^{th} time of iterative approximation of the L times of iterative approximation further comprises:
determining an i^{th} residual vector between the to-be-approximated vector and a product of the i^{th} column vector multiplied by the i^{th} coefficient.

6. The method according to any one of claims 3 to 5, wherein determining, based on the to-be-approximated vector, the i^{th} column vector in the i^{th} codebook matrix comprises:
determining, from a plurality of column vectors in the i^{th} codebook matrix, a column vector that has maximum correlation with the to-be-approximated vector as the i^{th} column vector.

7. The method according to any one of claims 1 to 6, wherein L is determined in any one of the following manners:
a preset value; or
a comparison between a residual of the i^{th} time of iteration and a predetermined threshold.

8. The method according to any one of claims 1 to 7, further comprising:
performing a matrix row permutation on an (i-1)^{th} codebook matrix used in the (i-1)^{th} time of iterative approximation, to obtain the i^{th} codebook matrix used in the i^{th} time of iterative approximation.

9. The method according to claim 8, wherein the matrix row permutation comprises one of the following:
a random matrix row permutation; or
a forward or backward matrix row cyclic shift based on a pre-determined shift amount.

10. The method according to claim 9, wherein one of the following:
using a same random matrix row permutation in a second time of iterative approximation to an L^{th} time of iterative approximation; or
respectively determining a random matrix row permutation used in the second time of iterative approximation to the L^{th} time of iterative approximation.

11. The method according to any one of claims 3 to 10, wherein a first codebook matrix used in the first time of iterative approximation is randomly generated or predetermined.

12. The method according to any one of claims 1 to 7, wherein the L codebook matrices used in the L times of iterative approximation are the same, and the method further comprises:
performing an element permutation on an (i-1)^{th} residual vector determined in the (i-1)^{th} time of iterative approximation, to obtain the to-be-approximated vector in the i^{th} time of iterative approximation.

13. The method according to claim 12, wherein the element permutation comprises one of the following:
a random element permutation; or
a forward or backward element cyclic shift based on a pre-determined shift amount.

14. The method according to any one of claims 1 to 13, further comprising:
determining the i^{th} coefficient based on a dimension n of the to-be-compressed data, an element variance σ of the to-be-compressed data, a column quantity m of the L codebook matrices, and a quantity i of times of iterative approximation.

15. The method according to claim 14, wherein the i^{th} coefficient is further determined based on a residual attenuation coefficient q, and the residual attenuation coefficient q represents an attenuation rate of a sum of squares of elements of a residual vector.

16. The method according to any one of claims 1 to 15, wherein the method is performed by a first device, and the method further comprises:
sending, to a second device, the compressed data obtained by compressing the to-be-compressed data.

17. The method according to any one of claims 1 to 16, wherein the compressed data comprises at least one of the following:
the L column numbers;
an element mean µ of the to-be-compressed data;
the element variance σ of the to-be-compressed data; or
a first coefficient used in the first time of iterative approximation.

18. The method according to any one of claims 1 to 17, wherein the method is performed by the first device, and the method further comprises configuring or indicating, to the second device, at least one of the following:
a compression manner of at least one of the element mean µ of the to-be-compressed data, the element variance σ of the to-be-compressed data, or the first coefficient used in the first time of iterative approximation;
the dimension n of the to-be-compressed data and the column quantity m of the L codebook matrices;
the residual attenuation coefficient q, wherein the residual attenuation coefficient q represents the attenuation rate of the sum of the squares of elements of the residual vector;
whether the first codebook matrix in the L codebook matrices is randomly generated or predetermined;
whether to perform the matrix row permutation on the (i-1)^{th} codebook matrix used in the (i-1)^{th} time of iterative approximation, or perform the element permutation on the (i-1)^{th} residual vector determined in the (i-1)^{th} time of iterative approximation; or
whether the matrix row permutation or the element permutation is a random permutation or a cyclic shift.

19. The method according to claim 18, wherein the compression manner comprises at least one of the following:
floating-point number representation;
uniform scalar quantization; or
skipping sending the element mean µ of the to-be-compressed data.

20. The method according to claim 18 or 19, wherein
the column quantity m of the L codebook matrices is determined based on a value of the dimension n.

21. The method according to any one of claims 18 to 20, wherein the first codebook matrix is randomly generated, and the method further comprises:
configuring or indicating, to the second device, a random number seed used to generate the first codebook matrix.

22. The method according to any one of claims 18 to 21, wherein the matrix row permutation or the element permutation is the random permutation, and the method further comprises configuring or indicating, to the second device, at least one of the following:
whether the same random matrix row permutation or the respectively randomly generated matrix row permutation is used in the second time of iterative approximation to the L^{th} time of iterative approximation; or
whether the random matrix row permutation reuses the random number seed used to generate the first codebook matrix in the L codebook matrices, or is configured with different random number seeds.

23. The method according to any one of claims 18 to 21, wherein the matrix row permutation or the element permutation is the cyclic shift, and the method further comprises configuring or indicating, to the second device, at least one of the following:
a forward cyclic shift or a backward cyclic shift; or
a shift amount.

24. The method according to any one of claims 1 to 23, wherein the method is performed by the first device, and the method further comprises:
sending a first message to the second device, wherein the first message is used to request, from the second device, a resource used to send the compressed data to the second device.

25. The method according to claim 24, wherein the first message comprises at least one of the following:
information that directly indicates a quantity L of times of iterative approximation; or
a data volume of the compressed data.

26. The method according to any one of claims 1 to 25, wherein the method is performed by the first device, and the method further comprises:
receiving a second message from the second device, wherein the second message indicates the resource that is scheduled by the second device to the first device and that is used to send the compressed data to the second device; and
sending the compressed data to the second device using the scheduled resource.

27. The method according to any one of claims 24 to 26, wherein at least one of the first message or the second message comprises indication information, and the indication information indicates that the resource is used for incremental transmission.

28. The method according to claim 27, wherein the compressed data sent to the second device corresponds to basic transmission data, and sending the compressed data to the second device comprises:
determining that a quantity of times of iterative approximation corresponding to the compressed data sent by using the resource scheduled based on the second message is L1, wherein L1 is less than L; and
sending, to the second device, a first column number to an L1^{th} column number in the L column numbers.

29. The method according to claim 27 or 28, wherein the indication information in the second message indicates that the resource is used for incremental transmission, compressed data of L1 times of iterative approximation has been sent in basic transmission before incremental transmission, and sending the compressed data to the second device comprises:
determining that the quantity of times of iterative approximation corresponding to the compressed data sent by using the resource scheduled based on the second message is L2-L1, wherein L1 is less than L2, and L2 is less than or equal to L; and
sending, to the second device, an (L1+1)^{th} column number to an L2^{th} column number in the L column numbers.

30. The method according to claim 28 or 29, wherein determining the quantity of times of iterative approximation corresponding to the compressed data sent by using the resource scheduled based on the second message comprises:
when the resource is used for the compressed data alone, determining the quantity of times of iterative approximation based on a quantity of resources; or
when the resource is used for the compressed data and other data, obtaining indication information of the quantity of times of iterative approximation from the second message.

31. A method, comprising:
obtaining, from compressed data obtained by compressing to-be-compressed data, L column numbers of L column vectors in L codebook matrices, wherein elements in the L codebook matrices are two different values;
determining the L column vectors based on the L column numbers and the L codebook matrices;
determining L coefficients corresponding to the L column vectors; and
obtaining an approximation of the to-be-compressed data based on the L coefficients and the L column vectors, wherein
L is greater than or equal to 1.

32. The method according to claim 31, wherein
the two different values comprise 1 and -1.

33. The method according to claim 31 or 32, wherein a first codebook matrix in the L codebook matrices is randomly generated or predetermined.

34. The method according to any one of claims 31 to 33, further comprising:
performing a matrix row permutation on an (i-1)^{th} codebook matrix in the L codebook matrices, to obtain an i^{th} codebook matrix in the L codebook matrices.

35. The method according to claim 34, wherein the matrix row permutation comprises one of the following:
a random matrix row permutation; or
a forward or backward matrix row cyclic shift based on a pre-determined shift amount.

36. The method according to claim 35, wherein one of the following:
obtaining a second codebook matrix to an L^{th} codebook matrix from the first codebook matrix to an (L-1)^{th} codebook matrix based on a same random matrix row permutation; or
obtaining the second codebook matrix to the L^{th} codebook matrix from the first codebook matrix to the (L-1)^{th} codebook matrix based on a respectively determined random matrix row permutation.

37. The method according to any one of claims 31 to 33, wherein the L codebook matrices are the same, and obtaining the approximation of the to-be-compressed data based on the L coefficients and the L column vectors comprising:
respectively multiplying the L coefficients and the L column vectors to obtain L product column vectors;
performing an element permutation one or more times on L-1 product column vectors other than a first product column vector, to obtain L product column vectors obtained through the element permutation; and
summing up the L product column vectors obtained through the element permutation to obtain the approximation of the to-be-compressed data.

38. The method according to claim 37, wherein the element permutation comprises one of the following:
a random element permutation; or
a forward or backward element cyclic shift based on a pre-determined shift amount.

39. The method according to any one of claims 31 to 38, further comprising:
determining an i^{th} coefficient corresponding to the i^{th} codebook matrix based on a dimension n of the to-be-compressed data, an element variance σ of the to-be-compressed data, a column quantity m of the L codebook matrices, and a sequence number i of the codebook matrix.

40. The method according to claim 39, wherein the i^{th} coefficient is further determined based on a residual attenuation coefficient q, and the residual attenuation coefficient q represents an attenuation rate of a sum of squares of elements of a residual vector in a process of performing iterative approximation encoding on the to-be-compressed data.

41. The method according to any one of claims 31 to 40, wherein the method is performed by a second device, and the method further comprises:
receiving, from a first device, the compressed data obtained by compressing the to-be-compressed data.

42. The method according to any one of claims 31 to 41, wherein the compressed data comprises at least one of the following:
the L column numbers;
an element mean µ of the to-be-compressed data;
the element variance σ of the to-be-compressed data; or
a first coefficient corresponding to a first column vector.

43. The method according to any one of claims 31 to 42, wherein the method is performed by the second device, and the method further comprises configuring at least one of the following or receiving, from the first device, information indicating at least one of the following:
a compression manner of at least one of the element mean µ of the to-be-compressed data, the element variance σ of the to-be-compressed data, or the first coefficient corresponding to the first column vector;
the dimension n of the to-be-compressed data and the column quantity m of the L codebook matrices;
the residual attenuation coefficient q, wherein the residual attenuation coefficient q represents the attenuation rate of the sum of the squares of elements of the residual vector in the process of performing iterative approximation encoding on the to-be-compressed data;
whether the first codebook matrix in the L codebook matrices is randomly generated or predetermined;
whether to perform the matrix row permutation on the (i-1)^{th} codebook matrix or perform the element permutation on a product vector of a column vector and a coefficient; or
whether the matrix row permutation or the element permutation is a random permutation or a cyclic shift.

44. The method according to claim 43, wherein the compression manner comprises at least one of the following:
floating-point number representation;
uniform scalar quantization; or
skipping sending the element mean µ of the to-be-compressed data.

45. The method according to claim 43 or 44, wherein
the column quantity m of the L codebook matrices is determined based on a value of the dimension n.

46. The method according to any one of claims 43 to 45, wherein the first codebook matrix is randomly generated, and the method further comprises:
configuring a random number seed used to generate the first codebook matrix or receiving, from the first device, information indicating the random number seed.

47. The method according to any one of claims 43 to 46, wherein the matrix row permutation or the element permutation is the random permutation, and the method further comprises configuring at least one of the following or receiving, from the first device, information indicating at least one of the following:
whether the same random matrix row permutation or the respectively randomly generated matrix row permutation is used for the second codebook matrix to the L^{th} codebook matrix; or
whether the random matrix row permutation reuses the random number seed used to generate the first codebook matrix in the L codebook matrices, or is configured with different random number seeds.

48. The method according to any one of claims 43 to 46, wherein the matrix row permutation or the element permutation is the cyclic shift, and the method further comprises configuring at least one of the following or receiving, from the first device, information indicating at least one of the following:
a forward cyclic shift or a backward cyclic shift; or
a shift amount.

49. The method according to any one of claims 31 to 48, wherein the method is performed by the second device, and the method further comprises:
receiving a first message from the first device, wherein the first message is used to request, from the second device, a resource used to send the compressed data to the second device.

50. The method according to claim 49, wherein the first message comprises at least one of the following:
information that directly indicates a quantity L of codebook matrices; or
a data volume of the compressed data.

51. The method according to any one of claims 31 to 50, wherein the method is performed by the second device, and the method further comprises:
sending a second message to the first device, wherein the second message indicates the resource that is scheduled by the second device to the first device and that is used to send the compressed data to the second device; and
receiving the compressed data from the first device using the scheduled resource.

52. The method according to any one of claims 49 to 51, wherein at least one of the first message or the second message comprises indication information, and the indication information indicates that the resource is used for incremental transmission.

53. The method according to claim 52, wherein the compressed data received from the first device corresponds to basic transmission data, and receiving the compressed data from the first device comprises:
when a quantity of codebook matrices corresponding to the compressed data sent by using the resource scheduled based on the second message is L1, receiving, from the first device, a first column number to an L1^{th} column number in the L column numbers, wherein L1 is less than L.

54. The method according to claim 52, wherein the indication information in the second message indicates that the resource is used for incremental transmission, compressed data of L1 codebook matrices has been received in basic transmission before incremental transmission, and receiving the compressed data from the first device comprises:
when a quantity of codebook matrices corresponding to the compressed data sent by using the resource scheduled based on the second message is L2-L1, receiving, from the first device, an (L1+1)^{th} column number to an L2^{th} column number in the L column numbers, wherein L1 is less than L2, and L2 is less than or equal to L.

55. The method according to claim 53 or 54, wherein
when the resource is used for the compressed data alone, the second message does not comprise indication information indicating a quantity of codebook matrices; or
when the resource is used for the compressed data and other data, the second message comprises the indication information indicating the quantity of codebook matrices.

56. An apparatus, comprising:
a to-be-compressed data obtaining module, configured to obtain to-be-compressed data;
an iterative approximation module, configured to perform L times of iterative approximation on the to-be-compressed data, wherein the L times of iterative approximation comprise: respectively selecting L column vectors from L codebook matrices to perform approximation on the to-be-compressed data, and elements in the L codebook matrices comprise two different values; and
a compressed data generation module, configured to generate, based on L column numbers of the L column vectors in the L codebook matrices, compressed data obtained by compressing the to-be-compressed data.

57. An apparatus, comprising:
a column number obtaining module, configured to obtain, from compressed data obtained by compressing to-be-compressed data, L column numbers of L column vectors in L codebook matrices, wherein elements in the L codebook matrices are two different values;
a column vector determining module, configured to determine the L column vectors based on the L column numbers and the L codebook matrices;
a coefficient determining module, configured to determine L coefficients corresponding to the L column vectors; and
an approximate vector obtaining module, configured to obtain an approximation of the to-be-compressed data based on the L coefficients and the L column vectors, wherein
L is greater than or equal to 1.

58. A device, comprising a processor and a memory storing instructions, wherein when the instructions are executed by the processor, the method according to any one of claims 1 to 53 is performed.

59. A computer-readable storage medium, wherein the computer-readable storage medium stores instructions, and when the instructions are executed by an electronic device, the electronic device is enabled to perform the method according to any one of claims 1 to 55.

60. A computer program product, wherein the computer program product comprises instructions, and when the instructions are executed by an electronic device, the electronic device is enabled to perform the method according to any one of claims 1 to 55.
